(19) Europäisches Patentamt
European Patent Office
Office européen des brevets

(11) **EP 2 812 997 B1**

(12) **EUROPÄISCHE PATENTSCHRIFT**

(45) Veröffentlichungstag und Bekanntmachung des Hinweises auf die Patenterteilung:
**11.07.2018 Patentblatt 2018/28**

(21) Anmeldenummer: **12816649.3**

(22) Anmeldetag: **15.12.2012**

(51) Int Cl.:
*H03M 3/00* *(2006.01)*    *H03M 7/30* *(2006.01)*

(86) Internationale Anmeldenummer:
**PCT/EP2012/005182**

(87) Internationale Veröffentlichungsnummer:
**WO 2013/087221 (20.06.2013 Gazette 2013/25)**

(54) **VORRICHTUNG MIT EINEM DELTA-SIGMA-MODULATOR UND EINEM MIT DIESEM VERBUNDENEN SCHALTENDEN VERSTÄRKER**

DEVICE HAVING A DELTA-SIGMA MODULATOR AND A SWITCHING AMPLIFIER CONNECTED THERETO

DISPOSITIF COMPORTANT UN MODULATEUR DELTA-SIGMA ET UN AMPLIFICATEUR À COMMUTATION RELIÉ À CELUI-CI

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **15.12.2011 DE 102011121139**

(43) Veröffentlichungstag der Anmeldung:
**17.12.2014 Patentblatt 2014/51**

(73) Patentinhaber: **iAd Gesellschaft für Informatik, Automatisierung und Datenverarbeitung mbH**
**90613 Grosshabersdorf (DE)**

(72) Erfinder:
• **HAMPEL, Hermann**
**90613 Grosshabersdorf (DE)**
• **BEROLD, Ulrich**
**90427 Nürnberg (DE)**
• **HANOUN, Abdulrahman**
**91560 Heilsbronn (DE)**
• **BÄNISCH, Andreas**
**90762 Fürth (DE)**
• **HAMPEL, Johannes**
**90613 Grosshabersdorf (DE)**
• **ECKHOF, Oliver**
**91468 Gutenstetten (DE)**
• **DEINZER, Manfred**
**91233 Neunkirchen am Sand (DE)**

(74) Vertreter: **Dreykorn-Lindner, Werner**
**Steinlachstrasse 2**
**90571 Schwaig (DE)**

(56) Entgegenhaltungen:
**WO-A1-2010/109453    DE-T2- 69 919 185**
**US-A1- 2010 085 118**

• **MAGRATH A J ET AL: "Hybrid pulse width modulation/sigmadelta modulation power digital-to-analogue converter", IEE PROCEEDINGS: CIRCUITS DEVICES AND SYSTEMS, INSTITUTION OF ELECTRICAL ENGINEERS, STENVENAGE, GB, Bd. 143, Nr. 3, 10. Juni 1996 (1996-06-10) , Seiten 149-156, XP006006113, ISSN: 1350-2409, DOI: 10.1049/IP-CDS:19960348**
• **ESSLINGER R ET AL: "Sigma-Delta Modulation in Digital Class-D Power Amplifiers: Methods for Reducing the Effective Pulse Transition Rate", AUDIO ENGINEERING SOCIETY CONVENTION 112, [Online] 5634, April 2002 (2002-04), XP040371897, 60 EAST 42ND STREET, NEW YORK, USA [gefunden am 2013-08-06]**

**Beschreibung**

Die Erfindung betrifft (gemäß den zwei nebengeordneten Patentansprüchen 1 und 2) eine Vorrichtung mit einem Delta-Sigma-Modulator und einem mit diesem verbundenen schaltenden Verstärker, insbesondere zur Aufbereitung des Eingangssignals mit niedrigem Überabtastverhältnis OSR und hohem Signal-zu-Rausch-Verhältnis SNR.

Aufgrund der Tatsache, dass ein schaltender Verstärker, insbesondere eine MOSFET-Endstufe im Schaltbetrieb nur eine sehr geringe Leistung im Sperrzustand ("Cut-off state") und Sättigungszustand verbraucht, bietet diese eine bessere Effizienz als linear arbeitende Verstärker. Theoretisch wird Leistung nur beim Umschalten zwischen diesen Zuständen verbraucht.

Oft gehen einem schaltenden Verstärker (Digitalverstärker) im Schaltbetrieb ein PDM (Pulsdauer Modulation)-Modul und/oder ein DSM (Delta-Sigma-Modulator)-Modul voran, welches das hochauflösende Signal in ein Signal mit niedriger Auflösung (1-Bit-Impulsfolge) mit viel höherer Frequenz konvertiert. Der Endstufe folgt häufig ein Tiefpass-Rekonstruktionsfilter, welcher das verstärkte Basisbandsignal wiederherstellt.

Delta-Sigma-Modulatoren, nachfolgend kurz DSM genannt, formen das Signal-zu-Rausch-Verhältnis (SNR) derart, dass sie das Rauschen im Frequenzbereich vom Signal wegschieben. Im Fachbuch "Understanding Delta-Sigma Data Converters" von Richard Schreier, Gabor Temes. Wiley Interscience Publication 2005, ISBN 0-471-46585-2 werden mehrere konventionelle DSM-Strukturen vorgestellt. Die dort beschriebenen Strukturen zielen auf Basisbandsignale mit niedrigen Abtastraten ab. Relativ hohe Überabtastverhältnisse mit hoher Ordnung des DSM (z.B. über 16) werden verwendet, um ein akzeptables SNR der Ausgangssignale zu garantieren. Im Fall sehr hoher Abtastraten des Basisbandsignals (über 2 MSps (Mega-Samples pro Sekunde)) sind jedoch nur niedrige Überabtastverhältnisse technisch möglich für die Leistungsverstärkung. Die elektrischen Eigenschaften der meisten Leistungsverstärkertransistoren verursachen für hochfrequente Eingangsimpulse eine starke Verschlechterung der Qualität des Ausgangssignals und der Verstärkungseffizienz.

Der für niedrige Abtastrate (RSR; reduced sampling rate) ausgelegte DSM (RSR-DSM) bietet die gleiche SNR-Größenordnung mit sehr viel niedrigerem OSR. Im Aufsatz "A Reduced-Sample-Rate Sigma-Delta-Pipeline ADC Architecture for High-Speed High-Resolution Applications" von Vahid Majidzadeh, Omid Shoaei veröffentlicht in IEICE Transactions 89-C(6): 692-701 (2006) wurden zwei praktische Beispiele für RSR Loop-Filter dargestellt. Die RSR-DSM 4. und 6. Ordnung liefern höhere SNR für ein niedriges OSR im Vergleich zu den konventionellen DSM Loop-Filtem.

Die Verwendung von Multi-Bit-Quantisierung im DSM erhöht das SNR und verbessert die Stabilität des DSM wie im Aufsatz "Delta-Sigma Modulators: modeling, design and application" von George Bouropoulos veröffentlicht in Imperial College Press 2003. ISBN1-86094-369-1 und in der Doktorarbeit "Stability Analysis and Design of Bandpass Sigma Delta Modulators" von Jurgen van Engelen, Technische Universität Eindhoven, 1999, ISBN 90-386-1580-9 diskutiert. Jedes Bit des Multi-Bit-Ausgang des DSM erfordert jedoch einen separaten Endstufen-Kanal mit gewichteter Stromversorgung. Die vorgenannte Lösung ist sehr kostenintensiv und wird aus technischen Aspekten nicht empfohlen.

Eine grundsätzliche Abhilfe für diesen Nachteil ist, einen Parallel-Seriell-Konverter an den Ausgang des Multi-Bit-DSM und vor der MOSFET-Endstufe im Schaltbetrieb CDA zu platzieren und somit einen 1-Bit-Impulsstrom in den CDA zu speisen. Dieses Konzept wird in der Doktorarbeit "Stability Analysis and Design of Bandpass Sigma Delta Modulators" von Jurgen van Engelen kurz erklärt, wobei dieses Konzept beispielsweise in einigen Patentmeldungen wie GB-A 2 438 774, GB-A 2 435 559 oder GB-A 2 406 008 verwendet wird.

Um die optimalen Koeffizienten für das Schleifenfilter im DSM zu finden, kann ein Suchalgorithmus verwendet werden, wie dieser beispielsweise im Aufsatz "An Automatic Coefficient Design Methodology for High-Order Bandpass Sigma-Delta modulator with Single-Stage Structure" von Hwi-Ming Wang veröffentlicht in IEEE Transactions on Circuits and Systems II, Juli 2006, Seiten 580-584 oder von Wan-Rone Liou, "A Low-Power Multi-Bit Delta-sigma Modulator with Data Weighted Averaging Technique", Workshop on Consumer Electronics and Signal Processing, 2005, Taiwan erklärt wird.

Im Stand der Technik wird häufig ein DSM mit einem Multi-Bit-Signal am Ausgang verwendet und es sind häufig Audiosignale zu verstärken, daher liegt dort ein deutlich niedrigerer Frequenzbereich, geringere Bandbreite sowie dementsprechend niedrigere Abtastraten vor. Bei den in den Patentanmeldungen GB-A 2 438 774, GB-A 2 435 559 oder GB-A 2 406 008 beschriebenen Lösungen hat die P/S-Wandlung starken Einfluss auf die Struktur des Schleifenfilters und dessen Parameter. Weiterhin erfordert die Steuerung des Flipping in diesen Patentanmeldungen GB-A 2 438 774, GB-A 2 435 559 oder GB-A 2 406 008 eine komplexe Steuerung/Logik.

Weiterhin ist aus der US-A 5,815,102 ein Digital-zu-Analog-(D/A)-Wandler, insbesondere ein Delta-Sigma-Wandler, für Audiosignale und verringertem Schalten bekannt. Audiofrequenzen des menschlichen Hörbereichs liegen im Bereich von 16 Hz bis 20 kHz. Ein derartiger D/A-Wandler wird insbesondere als nützlich für derartige Hörhilfen angesehen, welche - um einen Umgebungston zu empfangen - einen Audioreceiver bzw. -empfänger aufweisen, mit einem Analog-zu-Digital-Wandler, um die Tonfolgen bzw. den Ton in ein digitales Signal niedriger Rate und hoher Auflösung umzuwandeln, einer digitalen Verarbeitungsschaltung, um die Qualität des digitalen Signals niedriger Rate und hoher Auflösung zu modifizieren, einer Interpolatorschaltung, um das digitale Signal niedriger Rate und hoher Auflösung in ein Signal hoher Auflösung und mittlerer Rate umzuwandeln, und einem Digital-zu-Analog-Wandler, um das modifizierte digitale Signal mittlerer Rate und hoher Auflösung zurück in einen analogen Ton zu wandeln. Um einen Digital-zu-Analog-(D/A)-Wandler zur Verfügung zu stellen, der einen niedrigen Leistungsverbrauch aufgrund einer Reduktion in der Anzahl von Ausgabesignalübergangen aufweist, während eine niedrige Verzerrung aufrechterhalten wird, formatiert bei der Hörhilfe gemäß der US-A 5,815,102 ein Einschaltzyklus-Demodulator das digitale Signal niedriger Auflösung und hoher Rate um in ein vorbestimmtes Format einer niedrigen Übergangsrate. Hierzu wird ein Mehrbitwert entsprechend jedem eingegebenen bzw. Eingabewert des digitalen Signals mittlerer Auflösung und mittlerer Rate bestimmt und die so bestimmten Werte als ein digitales Signal niedriger Auflösung und hoher Rate ausgegeben. Beispielsweise kann der Einschaltzyklus-Demodulator einen Wert entsprechend jedem möglichen Eingabewert des digitalen Signals mittlerer Auflösung und mittlerer Rate (beispielsweise im ROM) speichern und den entsprechenden gespeicherten Wert für jedes eingegebene digitale Signal mittlerer Auflösung und mittlerer Rate nachschauen. Die Konvertierung der Eingangswerte in Ausgangswerte erfolgt also durch sogenannte "Formatierung" des Eingangssignals, die durch Nachschlagen von abgespeicherten Werten durchgeführt wird. Bei diesem alternierenden Format wachsen ungerade Zyklen von rechts und gerade Zyklen von links.

Schließlich ist aus der US 2010/0066580 A1 ein Audio-Digital-Analog (D/A)-Wandler bekannt, welcher digitale Audiosignale in analoge Audiosignale wandelt. Oversampling-Techniken werden typischerweise in einem Audio-D/A-Wandler verwendet, um die Genauigkeit des analogen Ausgangssignals zu verbessern, so dass es exakt das digitale Signal am Eingang des D/A-Wandler repräsentiert. Das in der US 2010/0066580 A1 benutzte Verfahren benötigt eine Tabelle mit mehreren Sequenzen pro Quantisierungslevel des Eingangssignals und hierbei jeweils eine positive und negative Sequenz. Zudem wird jeweils alterniert zwischen Sequenzen mit positiver und negativer "Gleichtaktenergie" (common mode energy), wobei die Sequenzen im gleichen "Satz" alle mit dem gleichen Binärwert beginnen und alle mit dem gleichen Binärwert enden. Da hierdurch je 2 Bits pro Sequenz bereits festgelegt sind, wird eine höhere Taktfrequenz des Ausgangssignals benötigt, wobei sich dies bei den in der US 2010/0066580 A1 betrachteten, niederfrequenten Audiosignalen nicht hindernd auswirkt.

Die grundsätzliche Problematik ist die Realisierung hoher Frequenzen in der Ausgangsstufe. Prinzipiell wäre eine möglichst hohe Quantisierung im DSM für eine bessere Signalqualität (SNR) am Ausgang gewünscht, d.h. eine möglichst hohe Auflösung des Quantisierers und damit möglichst viele Bits am Ausgang des DSM. Aber je höher die Quantisierung ist desto höher ist auch die benötigte Frequenz, um die Ausgangsstufe zu treiben (sofern die Auflösung der Ausgangsstufe niedriger ist als die des Quantisierers, wie im vorliegend betrachteten Fall gegeben ist). Weiterhin haben die Chip-Pads (genauer: die Die-Pads) auch TiefpassCharakteristik, wobei die Grenzfrequenz dieses Tiefpasses abhängig von der jeweils verwendeten Chip-Technologie ist. Je höher das Überabtastverhältnis (OSR) und damit die Taktfrequenz des Pads, umso größer wird der Frequenzbereich, in dem es aufgrund der Filterung der Pulse durch die Tiefpasscharakteristik Probleme am Chip-Pad gibt. Eine Verringerung der Überabtastverhältnis (OSR) führt zwangsweise zu einer niedrigen Verlustleistung und Signalverzerrung in dem schaltenden Verstärker.

Zusammenfassend kann festgestellt werden, dass im Stand der Technik, bei dem die Verstärkung von Audiosignalen betrachtet wird, deutlich niedrigere Nutzsignalbandbreiten und Abtastfrequenzen vorliegen, so dass die Realisierung der benötigten Frequenzen selbst bei hohem Überabtastverhältnis OSR eher unproblematisch ist. Als Beispiel kann auf die WO 2010/109453 A1 verwiesen werden, wobei die interessierenden Signale Audiosignale sind und für diese Audiosignale das Hauptziel die Reduzierung der Übergänge im PWM-Signal zur Steigerung der Effektivität und die Minimierung der Verluste in nachgeschalteten Vorrichtungen, insbesondere Class-D-Verstärker und dabei auch Reduktion des Jitters und Steigerung des SNR des Signals, angestrebt wird. Das Verfahren ist dadurch gekennzeichnet, dass jeweils die Pulse einer vordefinierten Anzahl N von Frames kombiniert und damit die Anzahl Übergänge innerhalb dieser Anzahl Frames minimiert werden. Das resultierende Signal hat durchschnittlich maximal zwei Übergänge pro N Frames. Da eine Anzahl größer zwei verwendet werden kann, kann die Anzahl der Übergänge ggf. weiter reduziert werden. Um die Phase des Signals nicht zu verfälschen, ist anschließend jedoch jeweils noch eine Neupositionierung des resultierenden, breiteren Pulses nötig. Das Vorgehen zur Reduzierung der Anzahl Übergänge ist beim Gegenstand der WO 2010/109453 A1 rein systematisch in Bezug auf eine vorgegebene Anzahl Frames und die Steuerung erfolgt hier nicht gedächtnisabhängig. Demnach bezieht das Gedächtnis nur eine vorgegebene Anzahl Frames ein, innerhalb deren die Pulse kombiniert und positioniert werden, jedoch keine vorangegangenen Frames. Die durch das Verfahren beim Gegenstand der WO 2010/109453 A1 eingeführte Latenz in der Signalverarbeitung ist relativ hoch und steigt proportional zur Anzahl zu kombinierender Frames an, wobei dort noch die Zeit für Bestimmung und Umsetzung der Pulsneupositionierung hinzukommt. Schließlich werden höhere OSR (>=16) verwendet, was bei den niedrigen Frequenzen im Audiobereich weniger problematisch ist.

Weiterhin kann auf die DE 699 19185 T2 verwiesen werden, welche sich auf DACs für Tonfrequenzen, genauer auf die Korrektur einer nicht linearen Ausgabe- bzw. Ausgangsverzerrung in Delta-Sigma-DACs bezieht. Dabei wird ein Delta-Sigma-Quantisierer 2. Ordnung bzw. ein darauf basierender Oversampling-DAC beschrieben, bei dem hohe Überabtastverhältnisse (als typische Faktoren werden von 32 bis 1024 genannt) für den fokussierten Audiobereich mit Frequenzen bis ca. 20 kHz verwendet werden. Weiterhin wird ein abwechselndes Format verwendet, in dem gerade Zyklen im Ausgangssignal von links anwachsen und ungerade von rechts, oder auch umgekehrt. Dabei wird die Anzahl der Datenübergänge im Ausgangssignal bereits auf die Hälfte reduziert gegenüber dem regelmäßigen Anwachsen aus der gleichen Richtung. Die Verwendung eines Formates mit abwechselnd von links oder rechts anwachsenden Signalen, kann durch die Verwendung von ROM-Tabellen realisiert werden. Die Auswahl der jeweiligen Tabelle erfolgt nur systematisch und im Audiobereich mit Frequenzen bis ca. 20 kHz. Schließlich wird die Verwendung einer Klasse-D-Ausgangsstufe durch den DAC beschrieben, nämlich zum Antreiben eines Ausgangslautsprechers.

Schließlich ist aus der US 2010/085118 A1 eine Totzeit-Verriegelungsschaltung mit mehreren Komparatoren für Signale im Audiobereich mit Frequenzen bis ca. 20 kHz bekannt, welche an einem Eingang eines Komparators das Ausgangssignal eines Dreiecksignalgenerators verwendet. Das Ziel der in der US 2010/085118 A1 beanspruchten Totzeit-Verriegelungsschaltung besteht damit in der Sicherstellung und Optimierung der Totzeit der schaltenden Elemente am Ausgang des schaltenden Verstärkers. Die Totzeit-Verriegelungsschaltung benötigt dabei je eine komplette Schaltung zur Sperrung der Totzeit bei fallender Signalflanke bzw. bei steigender Signalflanke, so dass eine höhere Anzahl von Komparatoren, Phasendetektoren und schaltenden Elementen erforderlich ist.

Für Leistungselektronik sind höhere Frequenzen (als im Audiobereich) ein große Herausforderung, da hier - durch höhere Schaltfrequenzen - Signalverzerrungen am Eingang der Verstärker entstehen.

Der Erfindung liegt die Aufgabe zugrunde, eine Vorrichtung mit einem Delta-Sigma-Modulator für einen schaltenden Verstärker und für höhere Frequenzen (als im Audiobereich) derart auszugestalten, dass eine Verringerung des Überabtastverhältnis (OSR) und der erforderlichen Taktfrequenz bei einer niedrigen Verlustleistung und Signalverzerrung im schaltenden Verstärker, insbesondere Vermeidung der Überlast des schaltenden Verstärkers, sowie das Clipping des Nutzsignals realisierbar ist.

Diese Aufgabe wird, gemäß Patentanspruch 1, durch eine Vorrichtung mit einem Delta-Sigma-Modulator und einem mit diesem verbundenen schaltenden Verstärker, bei der ein Audiosignal dem Eingang des Delta-Sigma-Modulators zugeführt wird und bei der am Multi-Bit-Ausgang des Delta-Sigma-Modulators eine Schaltung mit einem Parallel-Seriell-Umsetzers und einem Umdrehungsglied angeschlossen ist, wobei ein dem Delta-Sigma-Modulator zugeführtes Eingangssignal in ein Ein-bit PDM-ähnliches Ausgangssignals ya2 mit maximal einem Wechsel zwischen binären Einsen und Nullen oder Nullen und Einsen umgesetzt wird, dadurch gelöst, dass am Multi-Bit-Ausgang des Delta-Sigma-Modulators ein Parallel-Seriell Umsetzer SPS mit einer Reihenschaltung eines Parallel-Seriell-Umsetzers und eines nachgeordneten Umdrehungsgliedes für das serielle Ausgangssignal ya2 des Parallel-Seriell-Umsetzers angeschlossen ist und der Parallel-Seriell Umsetzer SPS als Pulsdauermodulator jeden M-Bit-Wert in ein Wort aus $N_{ps}$ binären Werten umsetzt, und dass das Umdrehungsglied abhängig vom letzten Bitwert 0 oder 1 eines jeweils vorhergehenden Wortes im resultierenden Ausgangssignal ya3 die Reihenfolge der binären Nullen und Einsen des aktuellen Wortes (sofern vorhanden) vertauscht, derart dass zur weiteren Reduzierung der Pulsflanken in dem Ausgangssignal ya2[i] des Parallel-Seriell Umsetzers des Parallel-Seriell Umsetzers SPS dieses unverändert im resultierenden Ausgangssignal ya3[i] des Umdrehungsglieds des Parallel-Seriell Umsetzers SPS übernommen wird, wenn ya3[i-l] mit demselben binären Wert endet wie ya2[i] beginnt, und ya2[i] umgedreht in ya3[i] übernommen wird, wenn ya3[i-1] mit dem entgegengesetzten binären Wert endet wie ya2[i] beginnt.

Weiterhin wird diese Aufgabe, gemäß Patentanspruch 2, durch eine Vorrichtung mit einem Delta-Sigma-Modulator und einem mit diesem verbundenen schaltenden Verstärker, bei der ein Audiosignal dem Eingang des Delta-Sigma-Modulators zugeführt wird und bei der am Multi-Bit-Ausgang des Delta-Sigma-Modulators eine Schaltung mit einem Parallel-Seriell-Umsetzers und einem Umdrehungsglied angeschlossen ist, wobei ein dem Delta-Sigma-Modulator zugeführtes Eingangssignal in ein Ein-bit PDM-ähnliches Ausgangssignals ya2 mit maximal einem Wechsel zwischen binären Einsen und Nullen oder Nullen und Einsen umgesetzt wird, dadurch gelöst, dass am Multi-Bit-Ausgang des Delta-Sigma-Modulators ein Parallel-Seriell Umsetzer SPS* mit einer Reihenschaltung aus einem Umdrehungsglied für das parallele Ausgangssignal yb1 des Delta-Sigma-Modulators und nachgeordnetem Parallel-Seriell-Umsetzer angeschlossen ist und der Parallel-Seriell Umsetzer SPS als Pulsdauermodulator jeden M-Bit-Wert in ein Wort aus $N_{ps}$ binären Werten umsetzt, und dass das Umdrehungsglied abhängig vom letzten Bitwert 0 oder 1 eines jeweils vorhergehenden Wortes im resultierenden Ausgangssignal yb3 die Reihenfolge der binären Nullen und Einsen des aktuellen Wortes (sofern vorhanden) vertauscht, derart dass zur weiteren Reduzierung der Pulsflanken in dem Ausgangsignal des Parallel-Seriell Umsetzers SPS* in dem Ausgangsignal yb2[i] des Umdrehungsglied dieses unverändert in yb3[i] übernommen wird, wenn yb3[i-1] mit demselben binären Wert endet wie yb2 [i] beginnt, und yb2[i] umgedreht in yb3[i] übernommen wird, wenn yb3[i-1] mit dem entgegengesetzten binären Wert endet wie yb2[i] beginnt.

Die erfindungsgemäßen Vorrichtungen ermöglichen eine deutliche Erhöhung der Energieeffizienz, eine Reduktion der Verlustleistung und einen variablen Versorgungsspannungsbereich und damit eine Adaption der Dynamik mit gleichem SNR. Der Delta-Sigma-Modulator fungiert dabei als Umsetzer, welcher Signale in bestimmter Auflösung in andere Signale anderer Auflösung umwandelt bzw. die in bestimmter Form vorliegenden Eingangssignale in Ausgangssignale anderer Form umwandelt, wobei die Signale ihre Information beibehalten. Insbesondere die Umsetzung von Analogsignalen unendlicher Auflösung in digitale Signale begrenzter Auflösung. Die Umwandlung erfolgt dabei derart, dass die Eigenschaften des Signals für den nachfolgenden schaltenden Verstärker optimiert werden.

Die Erfindung ist dabei nicht auf einen Typ von Delta-Sigma-Modulatoren DSMs eingeschränkt, sondern kann mit beliebigen DSMs umgesetzt werden, die zumindest ein bestimmtes Kriterium erfüllen. Dieses Kriterium ist eine niedrige Abtastrate, da zwischen Sigma-Delta-Modulator und schaltenden Verstärker (Digitalverstärker) eine Parallel-Seriell-Umsetzung erfolgt, deren erforderliche Taktfrequenz (mit der jeweils betrachteten Technologie) realisierbar sein muss, ebenso wie die des schaltenden Verstärkers.

Weitere Vorteile und Einzelheiten lassen sich der nachfolgenden Beschreibung einer bevorzugten Ausführungsform der Erfindung unter Bezugnahme auf die Zeichnung entnehmen. In der Zeichnung zeigt:

**FIG. 1a, 1b** zwei Ausgestaltungen der Architektur der erfindungsgemäßen Vorrichtung,
**FIG. 2** eine Ausgestaltung der Architektur des DSM nach **FIG. 1,**
**FIG. 3** zwei optimale Stellen für die Pole und Nullstellen des DSM nach **FIG. 2,**
**FIG. 4a, 4b, 4c** die Leistungsdichtespektren am Systemeingang, Quantisiererausgang und Systemausgang,
**FIG. 5** die Wahrscheinlichkeitsverteilung der Pulszahl für OFDM-Signal nach DSM,
**FIG. 6a, 6b** das Leistungsspektrum des Ausgangssignals eines PDM mit bzw. ohne Wort-Umdrehung für ein OFDM-Signal,
**FIG. 7a, 7b** das Leistungsspektrum des Ausgangssignals eines PDM mit bzw. ohne Wort-Umdrehung für ein Sinussignal,
**FIG. 8** das Prinzip des Pulsumdrehens am Beispiel eines Signalausschnitts gemäß der Erfindung,
**FIG. 9** eine weitere Ausgestaltung der Architektur der erfindungsgemäßen Vorrichtung,
**FIG. 10** eine Ausgestaltung der Architektur der erfindungsgemäßen Vorrichtung nach **FIG. 9** für den Fall der Wort-Umdrehung,
**FIG. 11** ein Ausführungsbeispiel für einen Mehrbit- schaltenden Verstärker CDA,
**FIG. 12** ein Ausführungsbeispiel für einen Verstärker CDA mit einer DDL-artigen Regelschleife,

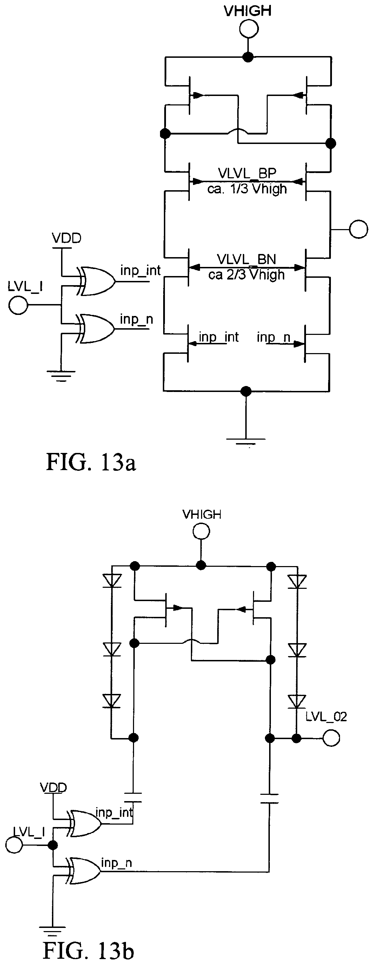

**FIG. 13a, 13b und 13b** drei Ausgestaltungen eines Anpassglieds und
**FIG. 14** eine Ausgestaltung für eine Schaltung zu Erzeugung eines variablen Versorgungsspannungsbereichs für einen schaltenden Verstärker.

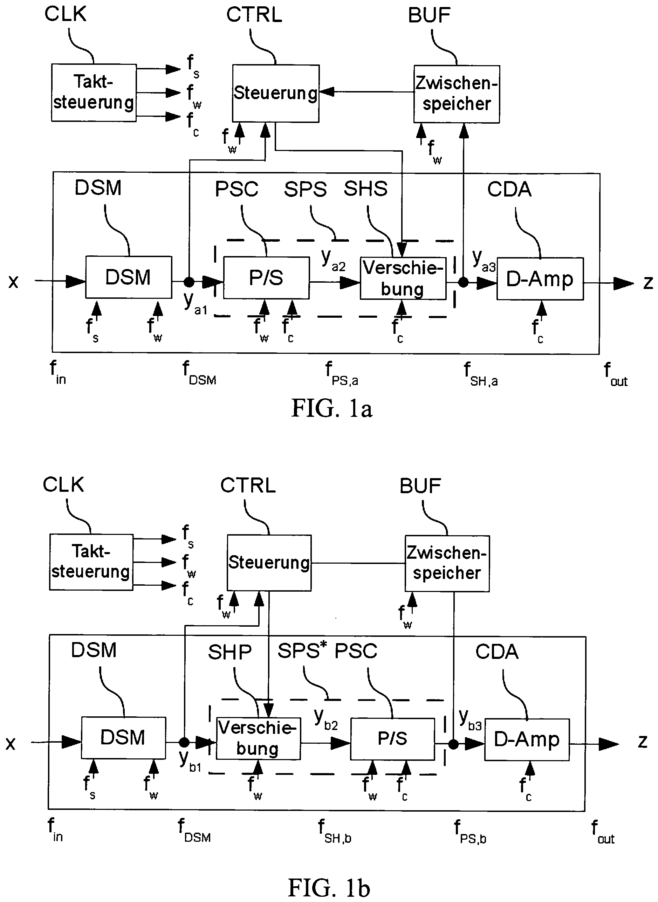

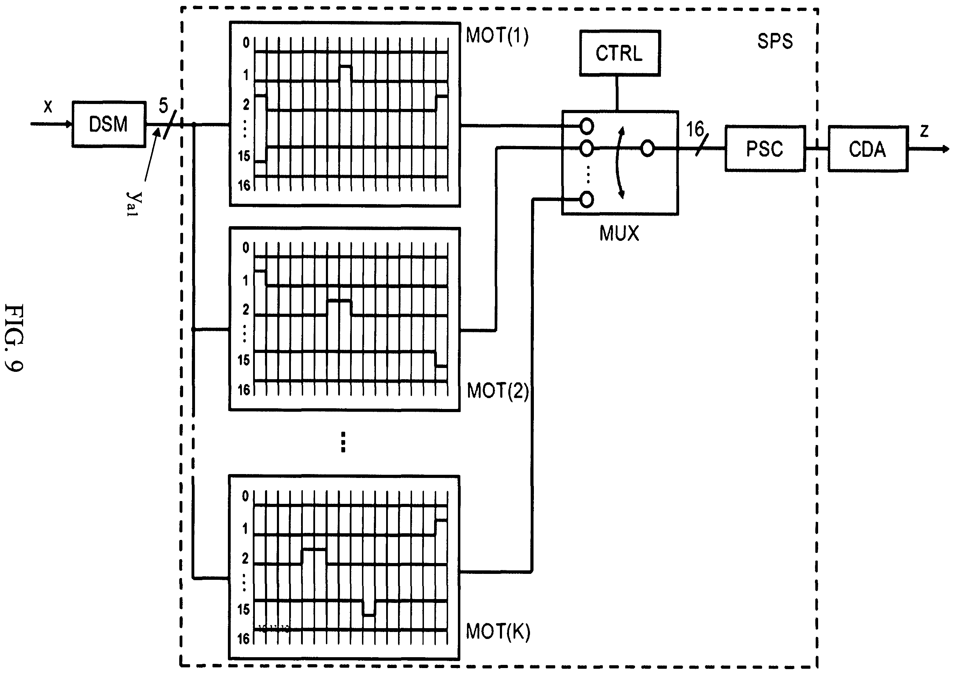

**FIG. 1a, 1b** zeigen zwei und **FIG. 9** eine weitere Ausgestaltung der Architektur der erfindungsgemäßen Vorrichtung mit einem Delta-Sigma-Modulator DSM und einem mit diesem verbundenen schaltenden Verstärker (Digitalverstärker) CDA insbesondere für den Anwendungsfall PLC (PowerLine Communication-(PLC)) - Systeme sind Nachrichtenübertragungssysteme, die Information über das Medium Energiekabel verteilen einschließlich über die Übertragungsstrecke zwischen Trafostation im Niederspannungsnetz und Kundenanlage im Haus). Für diesen Anwendungsfall PLC, insbesondere für den Fall der Schmalband-PLC im Frequenzbereich von etwa 9 bis 500 kHz, stehen unter Beachtung der jeweils gültigen Normen (z.B. der europäischen Norm (CENELEC EN 50065) oder der USamerikanischen Norm FCC Part 15 Subpart B) derzeit Techniken bereit, welche die bidirektionale Datenübertragung mit Raten von einigen hundert kBit/s erlauben. In der EN 50065 beispielsweise werden vier Frequenzbereiche, die dort maximal zulässigen Sendeamplituden und die Nutzungsrechte spezifiziert. Im Band A nutzen in Europa Energieversorgungsunternehmen den Bereich von 9 ... 95 kHz mit einer maximalen Sendeamplitude von 10V. Auf der Verbraucherseite steht in Europa der Bereich von 95 ... 148.5 kHz mit einer maximalen Sendeamplitude von 1,2V zur Verfügung (Band B bis Band D). Bei der Datenübertragung müssen Buskoppelbausteine, welche die Sende- und Empfangsfunktionen des Netzübertragungssystems erfüllen, den Besonderheiten Rechnung tragen, die durch die 230 V-Stromversorgungsleitung als Bus gegeben sind. Dazu gehören in erster Linie die Notwendigkeit der galvanischen Trennung zwischen Bus und Applikation, zweitens das Problem der variierenden Impedanz des jeweiligen Punktes im Versorgungsnetz, an dem der Buskoppelbaustein angeschlossen ist, drittens die damit verbundenen Unterschiede im auf das Netz aufgeprägten Sendepegel und der damit verbundenen Sendereichweite und viertens der Signalempfang unter Präsenz verschiedener Netzstörungen im Sendefrequenzband, wie z. B. Surge- und Burst-Impulse sowie verschiedene Formen des Rauschens, sowie der Verzerrungen des Kanals.

Bei der ersten Ausgestaltung (siehe **FIG. 1a**) ist am Multi-Bit-Ausgang des Delta-Sigma-Modulators DSM ein Parallel-Seriell-Umsetzer SPS, bestehend aus einer Reihenschaltung eines Parallel-Seriell-Umsetzers PSC und eines nachgeordneten Umdrehungsgliedes SHS angeschlossen und bei der zweiten Ausgestaltung (siehe **FIG. 1b**) ist ein Parallel-Seriell-Umsetzer SPS*, bestehend aus einer Reihenschaltung eines Umdrehungsgliedes SHP und dem nachgeordneten Parallel-Seriell-Umsetzer PSC angeschlossen, wodurch ein dem Delta-Sigma-Modulator DSM zugeführtes Eingangssignal mit niedrigem Überabtastverhältnis und hohem Signal-zu-Rausch-Verhältnis aufbereitet wird. Dabei liegt am Eingang des schaltenden Verstärkers CDA ein Ein-Bit-Signal an. Ein Ein-Bit- Schaltelement -Verstärker weist gegenüber Mehrbit- Schaltelement -Verstärkern geringere Stromverluste auf. Schaltelemente können beispielsweise als MOSFET, IGBT (insulated-gate bipolar transistor, Bipolartransistor mit isolierter Gate-Elektrode) oder CMOS (Halbleiterbauelemente, bei denen sowohl p-Kanal- als auch n-Kanal-MOSFETs auf einem gemeinsamen Substrat verwendet werden) ausgeführt sein.

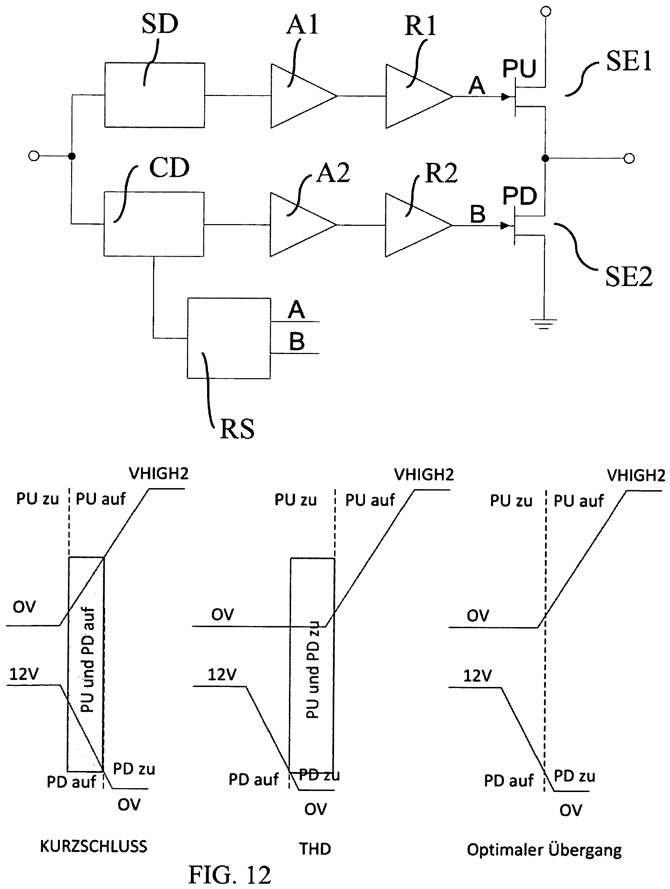

Grundlage des nachfolgend beschriebenen erfindungsgemäßen schaltenden Verstärker CDA ist es, einen Resonanzkreis aus der Gatekapazität des Ausgangstransistors und einer zu integrierenden Spule aufzubauen. Ein großer Vorteil dieser Struktur ist es, dass Energie beim Umschalten gespeichert werden kann, wodurch der Wirkungsgrad steigt. Allerdings ist zu beachten, dass um den hohen Wirkungsgrad von 90% zu erreichen möglichst viel Energie gespeichert werden muss. Dies würde jedoch eine große Induktivität erfordern, welche aber einen höheren Ladewiderstand darstellt und sich kaum auf dem Chip integrieren lässt. Außerdem nehmen integrierte Spulen große Flächen ein, was die Chipgröße erhöht. Es ist daher ein Kompromiss aus Gate-Treiber Spule und Ausgangstreiber notwendig, welcher dazu führen kann, dass eventuell mehrere Resonanz-Stufen aufgebaut werden müssen, um die Anforderung bezüglich der Pulsbreite bis zum Ausgangstreiber erfüllen zu können. Vorzugsweise besteht der schaltende Verstärker CDA aus zwei parallelen Zweigen mit jeweils einer in Serie liegenden Verzögerungsschaltung SD, CD, einem Anpassglied A1, A2 zur Anpassung der Versorgungsspannung eines Schaltelements S1, S2 und einem Resonanztreiber R1, R2 zur Schaltung des Schaltelements S1, S2 besteht. Weiterhin werden in einer DLL-artigen Regelschleife die Schaltflanken am Ausgang des Resonanztreibers R1, R2 abgegriffen und einem Phasenvergleicher zugeführt und aus der Differenz wird mittels einer Regelschaltung die Verzögerungszeit bestimmt und die Verzögerungsschaltung CD entsprechend eingestellt. Bei der in **FIG. 12** dargestellten Ausführungsform weist die Verzögerungsschaltung SD eine feste Verzögerungszeit auf, während die Verzögerungszeit Verzögerungsschaltung CD variabel einstellbar ist, d.h. es erfolgt eine dynamische Regelung des Signalversatzes. Dadurch können auf vorteilhafte Art und Weise Temperatur, Alterung, Bauteilvarianzen (Streuung der Prozessparameter) und Spannungsschwankungen kompensiert werden. Durch die Spannungsregelung wird auch das Schaltverhalten verändert, so dass eine Regelung (Spannungsregelung) in der Regelung (nachgeführte Flankenregelung) erreicht wird. Die Schaltelemente S1, S2 müssen mit einer gewissen Präzision angesteuert werden, damit möglichst keine Querströme zwischen den Schaltelementen S1, S2 auftreten und gleichzeitig möglichst geringe Totzeiten, in denen beide Transistoren geschlossen sind, eingehalten werden. Hierzu ist es notwendig, die Flanken der Ansteuersignale genau aufeinander abzustimmen. Dies wird erfindungsgemäß durch Messung und anschließende Trimmung vorgenommen werden. Der erfindungsgemäße Ansatz basiert auf den Entwurf einer DLL-artigen Regelschleife, welche die Flanken und Pulsbreiten derart abstimmt, dass beide Kriterien bestmöglich erfüllt sind. Weiterhin basiert der Ansatz auf regelbaren Delay-Elementen (Verzögerungsschaltung CD) und einem Phasendetektor. Dabei ist sicherzustellen, dass der Fall, dass beide Schaltelemente/Transistoren S1, S2 gleichzeitig leitend sind, vermieden wird, da dieser Betriebszustand zur Zerstörung der Bauelemente führt und dass die Signalformen, die der Ansteuerung des schaltenden Verstärker CDA dienen, verwendbar sind.

Die Eingangssignale für den schaltenden Verstärker CDA werden von einem digitalen IC mit 3.3V Logikpegel (Ausgang des Parallel-Seriell-Umsetzer SPS) geliefert. Daher muss der Logikpegel zum Ansteuern der Resonanztreiber R1, R2 umgesetzt werden. Durch die Spezifikation ergeben sich harte Anforderungen an das Anpassglied A1, A2:

- wenig Stromverbrauch und

- schnelles Umsetzen von 3.3V in Spannungen < 40V

Alle im Folgenden in den **FIG. 12a, b** und **c** gezeigten Lösungsansätze zeigen ein vergleichbares Verhalten, sowohl im Zeitverhalten als auch im Stromverbrauch. Unterschiede ergeben sich hingegen in der Komplexität. Prinzipbedingt ergibt sich das Problem der Flankenregeneration sobald die Versorgungsspannung > 24V wird. In diesem Fall muss wieder auf die Beschränkung durch $U_{GS(MAX)}$ berücksichtigt werden. Für die Ansteuerung der PullDown-Transistoren sind lediglich 12V-Transistoren notwendig, was dem Flächenverbrauch und der Geschwindigkeit zu Gute kommt.

Generell wird das Anpassglied A1, A2 nur dann benötigt, wenn die Versorgungspannung ein gewisses Niveau übersteigt. Insbesondere für den Fall der minimalen Versorgung von 2V kann auf die Umwandlung verzichtet werden. Um eine ordnungsgemäße Ansteuerung auch in diesem Fall zu gewährleisten muss eine Kommunikation zwischen der Stromversorgung und dem Signalpfad vorgesehen werden. Je nach gewählter Versorgungsspannung kann so der optimale Signalpfad zur Ansteuerung ausgewählt werden.

Durch das erfindungsgemäße Konzept ist es möglich, dass auch minimale Pulsbreiten von 3.9ns noch durchgeschaltet werden können. Der Wirkungsgrad, der mittels Leistungsmessung der einzelnen Transistoren bestimmt wurde, liegt dabei zwischen 91% und 93%. Für die Endstufe können Transistoren, welche aus 40V Varianten aufgebaut werden, ausgewählt werden, wodurch sich etwa 30-40% Fläche einsparen und die Anforderungen an die Ansteuerung sich günstiger gestalten lassen.

In beiden Fällen des Endstufentyps sind zusätzliche Versorgungsspannungen notwendig. Das **NN**-Konzept benötigt eine geboostete Versorgung für den PullUp, eine um 12V darunter liegende Spannung für den Gatetreiber, sowie eine 12V-Spannung für den PullDown. Der **PN**-Ansatz benötigt ebenfalls die 12V sowie die um 12V reduzierte Versorgung. Welcher eingesetzt wird, hängt von der Dimensionierung der Ausgangsstufe und der sich dadurch ergebenden Effizienz ab.

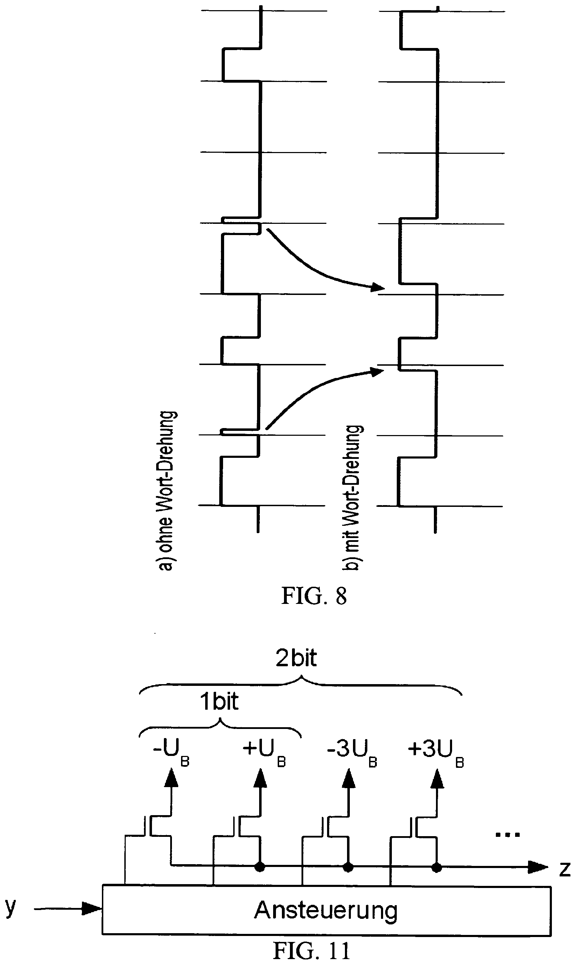

In einem in **FIG. 11** dargestellten Ausführungsbeispiel für eine Mehrbit- MOSFET-Endstufe CDA werden entsprechend der Anzahl Bits (hier: M-_CDA=2)$2^{M-\_CDA}=2^2=4$ Potentiale über MOSFET-Schalter an den Ausgang z geführt. Entsprechend des jeweiligen Eingangssignals y (entsprechend $y_{a3}$ bzw. $y_{b3}$ in **FIG. 1a / b**), schaltet eine Ansteuerung (Steuerung CTRL) im Chiptakt $f_c$ das jeweilige Potential auf den Ausgang z.

Weiterhin findet im DSM bzw. am Eingang des DSM eine Überabtastung mit einem bestimmten Überabtastfaktor (OSR) statt. Generell gilt, dass das erzielbare Signal-Rausch-Verhältnis (SNR) mit steigendem Überabtastfaktor (OSR) zunimmt. Zur Erzielung eines möglichst hohen SNR wäre dementsprechend ein möglichst hoher Überabtastfaktor (OSR) gewünscht. Andererseits sind jedoch verwendbare Überabtastfaktoren (OSR) im Hinblick auf die daraus resultierende Schaltfrequenz am Eingang des schaltenden Verstärkers und die damit verbundene Realisierungsproblematik begrenzt.

Nach der Überabtastung findet die Filterung des Signals in einem Schleifenfilter (Loop-Filter) statt. Das Schleifenfilter beinhaltet prinzipiell ein Signalübertragungsfilter (Signal-Transfer-Filter) für das Eingangssignal des DSM und ein Rauschübertragungsfilter (Noise-Transfer-Filter) für das rückgekoppelte Signal vom Ausgang eines Quantisierers Q des Delta-Sigma-Modulators DSM. Konventionelle Filter haben hierbei das Problem, dass sie im Bereich der in Frage kommenden Überabtastfaktoren (OSR) nicht das benötigte bzw. gewünschte Signal-Rausch-Verhältnis (SNR) erzielen. Daher kommt hier kein konventionelles Filter zum Einsatz, sondern ein auf reduzierte Abtastrate ausgelegtes Filter, ein sogenanntes RSR-Filter (RSR: Reduced-Sampling-Rate). Konventionelle Filter bzw. deren Verwendung sind beispielsweise im Fachbuch "Understanding Delta-Sigma Data Converters" von Richard Schreier und Gabor Temes, Wiley Interscience Publication 2005, ISBN 0-471-46585-2 Seite 91ff, beschrieben; RSR-Filter sind zum Beispiel aus dem Artikel "Low-Voltage Sigma-Delta Modulator Topologies For Broadband Applications" von Mohammed Yavari und Omid Shoaei veröffentlicht in IEEE International Symposium on Circuits and Systems, ISCAS 2004, Seiten 465-468 bekannt.

Für den betrachteten Einsatz kommen als RSR-Filter solche Filter in Betracht, die auf die jeweiligen Systemparameter (Signalbandbreite, Abtastfrequenz, Überabtastfaktor (OSR)) optimiert sind.

Bei Verwendung von RSR-Filtern liegen die Signal-Rausch-Verhältnisse (SNR) im Bereich der in Frage kommenden Überabtastfaktoren (OSR) deutlich höher gegenüber konventionellen Filtern. Die Realisierung der erfindungsgemäßen Lösung zeigt, dass die Verwendung von RSR-Filtem damit am Ausgang des Parallel-Seriell-Umsetzers PSC zu einer deutlich (z.B. um Faktor 3) niedrigeren Schaltfrequenz führt.

Der DSM ist vorzugsweise rekonfigurierbar ausgeführt, um eine flexible Anpassung an verschiedene Systemparameter (z.B. Übertragungsparameter wie das verwendete Frequenzband) zu ermöglichen; hierzu werden die Koeffizienten in ein spezielles Register (in der Zeichnung nicht dargestellt) geschrieben. Beispiele für die im Register gespeicherten Systemparameter sind:

- Abtastrate $f_s$
- Wortrate $f_w$
- Chiprate $f_c$
- Parameter a1, a2, b1, b2 des Schleifenfilters (insbesondere RSR-Filter).

Bei dem im Rahmen der Erfindung betrachteten Leistungsverstärker handelt es sich um Leistungselektronik, bspw. aus C-MOS-Transistoren, die aufgrund ihrer (technologieinhärenten) relativ langen Schaltflanken einer starken Beschränkung bezüglich der verwendeten Taktfrequenzen unterliegt. Diese haben zur Folge, dass - ab einer gewissen Frequenz - Pulse von sehr kurzer Dauer nicht mehr erkannt werden und daher Fehler in der Signalverarbeitung resultieren, die zu einer Verschlechterung des SNR am Ausgang führen.

Da am Ausgang des DSM ein Multi-Bit-Signal vorliegt, der CDA erfindungsgemäß ein Ein-Bit-Signal erwartet, ist zwischen den zugehörigen Funktionsblöcken eine Signalkonvertierung erforderlich. Diese Signalkonvertierung erfolgt Parallel-Seriell-Umsetzer SPS bzw. SPS* derart, dass bei möglichst günstigen Realisierungsbedingungen ein möglichst hohes SNR am Ausgang des schaltenden Verstärkers CDA auftritt.

Die Realisierung dieses erfindungsgemäßen Parallel-Seriell-Umsetzer SPS bzw. SPS* kann - wie bereits oben ausgeführt - durch den P/S-Block PSC und den nachgeschalteten Umdrehungsblock SHS erfolgen (siehe **FIG. 1a**) oder alternativ gemäß **FIG. 1b** durch den Umdrehungsblock SHP und den nachgeschalteten P/S-Block PSC. Die nachfolgende Beschreibung bezieht sich auf die Ausgestaltung nach **FIG. 1a.**

Der P/S-Block PSC ist mit dem Delta-Sigma-Modulators DSM und wandelt das Multi-bit-Ausgangssignal $y_{a1}$ des Quantisierers Q des DSM mit der Tastfrequenz $f_{DSM}$ bei M Bits in ein Ein-bit PDM-ähnliches Signal $y_{a2}$ (PDM Pulsdauermodulation) mit der Tastfrequenz $f_{PS,a}$. Dabei wird, abhängig vom jeweils anliegenden Multi-Bit-Wert des Eingangssignals $y_{a1}$, bei konstanter Frequenz der Tastgrad (Breite) des Ausgangssignals $y_{a2}$ moduliert. Das heißt, jeder M-Bit-Wert wird in ein Wort aus $N_{PS}$ aufeinanderfolgenden binären Werten umgesetzt, die erfindungsgemäß den M-Bit-Wert ähnlich einem PDM-Wert darstellen. Das bedeutet, dass pro Wort des Ausgangssignals $y_{a2}$ maximal ein Wechsel zwischen binären Einsen und Nullen bzw. Nullen und Einsen auftreten kann.

Entscheidend bei der Abbildung zwischen Multi-Bit-Wert des Eingangs $y_{a1}$ und des Ausgangs $y_{a2}$ ist, dass diese linear vorgenommen wird. Aus dieser Parallel-Seriell-Umsetzung resultiert folglich ein Signal, das höchstens einen Übergang zwischen Binärwerten (Einsen und Nullen bzw. umgekehrt) jeweils an den Wortgrenzen und/oder einen Übergang zwischen Binärwerten jeweils innerhalb eines Wortes enthält.

Die bei P/S-Umsetzung erforderliche Taktvervielfachung erfolgt mit einem Faktor, der gleich der Wortlänge $N_{PS}$ (Wortlänge des PDM-ähnlichen Signals am Ausgang des P/S-Converters PSC) ist. Die Wortlänge $N_{PS}$ und somit auch der Faktor zur Taktvervielfachung werden dabei abhängig vom genutzten Wertebereich von $y_{a1}$ bzw. der Anzahl $N_{DSM}$ (Anzahl möglicher, von $y_{a1}$ angenommener Werte am Ausgang des DSM; entspricht dem Überabtastfaktor (OSR)) möglicher, von $y_{a1}$ angenommener Werte gewählt. Bei der Wahl von $N_{PS}$ ist zu berücksichtigen, dass einerseits alle $N_{DSM}$ möglichen Werte von $y_{a1}$ in oben genannter Weise umkehrbar eindeutig auf ein Wort des Ausgangs $y_{a2}$ abgebildet werden können und dass andererseits im Hinblick auf die Realisierung ein möglichst niedriger Faktor zur Taktvervielfachung $N_{PS}$ resultiert.

Vorzugsweise wird unter Berücksichtigung dieser beiden Kriterien

$$N_{PS} = N_{DSM} - 1$$

gewählt.

Zur Reduktion der Schaltfrequenz wird nun erfindungsgemäß in einem weiteren Schritt, nämlich im Block SHS, ein adaptives, gedächtnisbehaftetes Umdrehen der Pulse vorgenommen und dabei das Eingangssignal $y_{a2}$ wortweise in das Ausgangssignal $y_{a3}$ überführt. Abhängig vom letzten Bitwert (0 oder 1) des jeweils vorhergehenden Wortes im resultierenden Ausgangssignal $y_{a3}$ wird der aktuelle Puls ggf. umgedreht oder unverändert ins Ausgangssignal $y_{a3}$ übernommen, derart, dass die Anzahl der Pulsflanken (d.h. Wechsel vom Bitwert 0 auf 1 bzw. umgekehrt) in $y_{a3}$ minimiert wird. Das erste Wort wird vorzugsweise unverändert übernommen, im Rahmen der Erfindung kann jedoch auch hier das Umdrehen durchgeführt werden. Die Taktsteuerung stellt (siehe **FIG. 1a**) die Takte fs (Abtasttakt), fw (Worttakt) und fc (Chip-/Bittakt) bereit, von denen die jeweils benötigten an den einzelnen Funktionsblöcken anliegen. Somit wird im Worttakt das jeweils letzte Bit des vorangegangenen Wortes aus dem Signal $y_{a3}$ im Zwischenspeicher BUF zwischengespeichert. Die Steuerung CTRL wiederum steuert abhängig vom Bitwert im Zwischenspeicher BUF und dem aktuellen Wort am Ausgang des DSM, insbesondere dem 1. Bit, die Verschiebung im Block SHS.

Unter dem Umdrehen des Pulses wird dabei verstanden, dass die Reihenfolge der binären Nullen und Einsen dieses Pulses (sofern vorhanden) vertauscht wird. Das heißt, aus einem Wort (Puls) beginnend mit k binären Einsen gefolgt von ($N_{PS}$-k) binären Nullen wird im Falle eines Umdrehens ein Wort (Puls) beginnend mit ($N_{PS}$-k) binären Nullen gefolgt von k binären Einsen. Die Anzahl Nullen und Einsen eines Pulses bleibt somit durch das Umdrehen unverändert, lediglich deren Reihenfolge ändert sich.

Durch diese erfindungsgemäße Art der Parallel-Seriell-Wandlung mit adaptivem, gedächtnisbehaftetem Umdrehen der Pulse entfallen somit die Pulsflanken an den Wortgrenzen, während die Pulsflanken innerhalb der Wortgrenzen weiter bestehen - wenn auch gegebenenfalls verschoben - so dass letztendlich die Anzahl der Pulsflanken am Eingang des schaltenden Verstärkers CDA (Digitalverstärker) durch das Umdrehen deutlich reduziert (genauer: annähernd halbiert) wird. Diese Reduzierung resultiert im gleichen Maß für die Schaltfrequenz der Halbleiterelemente in der Endstufe sowie für die an den Chip-Pads anliegenden Signale.

Die Auswirkungen dieses Umdrehens auf die Signalform sind vernachlässigbar, das Signal erfährt hierdurch keine relevante/nennenswerte Verfälschung. Andererseits lässt jedoch die erzielte Halbierung der Schaltfrequenz bei gleicher Technologie eine höhere Abtastfrequenz am Eingang des DSM bzw. einen höheren Überabtastfaktor (OSR) zu, wodurch ein höheres SNR am Ausgang erzielbar ist.

Ein weiterer Vorteil dieses Umdrehens ist, dass bei konventionellem Pulsdauermodulator PDM die Trägerfrequenz als markanter Signalanteil im Ausgangssignal vorhanden ist, da die steigende Flanke innerhalb eines Wortes (genauer: an den Wortgrenzen) immer an der gleichen Stelle (d.h. im gleichen Abstand) kommt. Bei dem erfindungsgemäßen Verfahren dagegen gibt es keine Flanken des PDM-Signals mehr an festen Stellen. Dadurch tritt bei der Trägerfrequenz kein signifikanter Anteil mehr auf, sondern dieser wird auf mehrere Frequenzen (um die Trägerfrequenz) aufgeteilt ("verschmiert"). Dies ermöglicht eine vereinfachte Grenzwerteinhaltung bei den Sendespektralmessungen zur Einhaltung von Normen.

Anhand des nachfolgenden Ausführungsbeispiels wird das erfindungsgemäße Verfahren weiter beschrieben und erläutert. Es soll ein Nutzsignal innerhalb eines Frequenzbereiches von etwa 10 kHz bis 500 kHz verstärkt werden, das Bandbreiten von 10 kHz bis 400 kHz annehmen kann. Das zu verstärkende Signal liegt am Eingang mit einer Abtastrate von ca. 2 MSps bei einer Auflösung von 12 Bit vor. Das Eingangssignal, das im betrachteten Fall ein OFDM-Signal ist, hat einen dynamischen Bereich von ca. 87 % der 12-bit Auflösung. Mittels der erfindungsgemäßen Vorrichtung soll nun mit einem niedrigen Überabtastfaktor (OSR) von 8 ein Gesamt-SNR von mehr als 60 dB erzielt werden. Die anvisierte Schaltfrequenz für den Ausgang des DSM (d. h. am Eingang des schaltenden Verstärkers) ist ca. 8 MHz. Dabei ist zwischen zwei Frequenzen zu unterscheiden, nämlich der Trägerfrequenz und der höchsten Harmonischen.

Die Trägerfrequenz wird wie folgt berechnet:

$$\text{Abtastfrequenz des Eingangssignals} \cdot \text{Überabtastfaktor des DSM} / 2$$

Der Faktor ½ kommt von der Wort-Umdrehung, so dass im Ausführungsbeispiel die Trägerfrequenz bei 2 MHz • 8/2 = 8 MHz liegt.

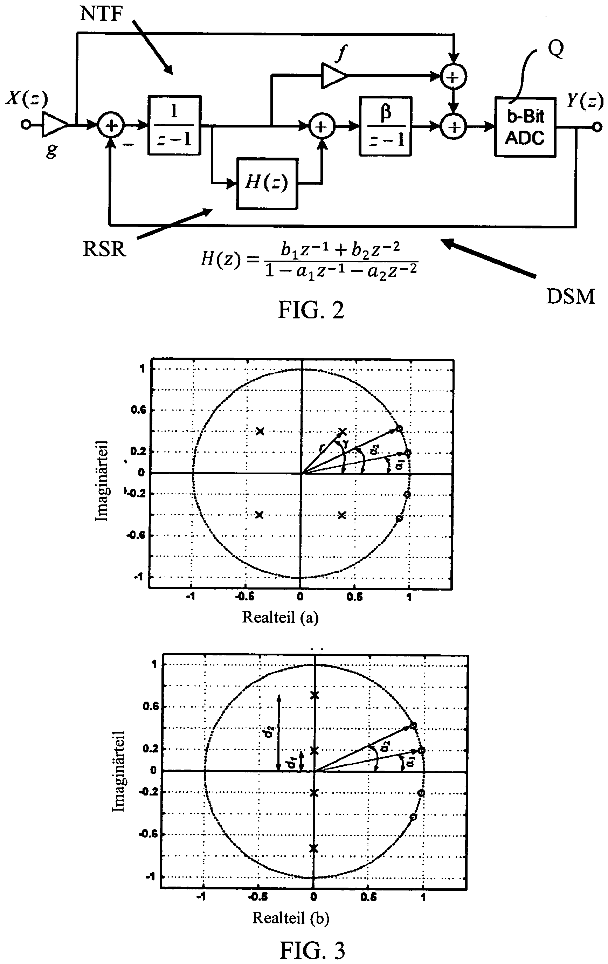

Als DSM kommt hier eine Architektur 4. Ordnung, wie in **FIG. 2** dargestellt, zum Einsatz, welche an sich aus dem Aufsatz "A Reduced-Sample-Rate Sigma-Delta-Pipeline ADC Architecture for High-Speed High-Resolution Applications" von Vahid Majidzadeh und Omid Shoaei veröffentlicht in IEICE Transactions 89-C(6): 692-701 (2006) bekannt ist.

Ein spezielles Schleifenfilter aus der Klasse der RSR-Filter (Reduced-Sampling-Rate-Filter), mit einem NTF-Filter höherer Ordnung, sorgt dabei für höhere SNR-Werte bei niedrigen Überabtastverhältnissen (OSR). Die Übertragungsfunktion H(z) lautet wie folgt:

$$H(z) = \frac{b_1 z^{-1} + b_2 z^{-2}}{1 - a_1 z^{-1} - a_2 z^{-2}}$$

Der Quantisierer unterscheidet hier $N_{DSM}=17$ Stufen am Eingang und wandelt diese jeweils in einen 5-Bit-Wert (d.h. M=5). Jeder 5-Bit-Wert am Eingang des Parallel-Seriell-Konverters PSC wird von diesem in ein binäres Wort der Länge $N_{PS}= N_{DSM}-1=16$ konvertiert. Für die nachfolgende Darstellung kann vereinfachend angenommen werden, dass die 5-Bit-Werte des Signals $y_{a1}$ im Wertebereich [0; 16] vorliegen. Die P/S-Konvertierung des Wertes $y_{a1}[n]$ kann dann bspw. erfolgen durch $y_{a1}[n]$ binäre Einsen und ($N_{PS}- y_{a1}[n]$) nachfolgende Nullen. Dies ist im nachfolgenden Beispiel für die Werte $y_{a1}[n]$ von 9, 4 und 10 dargestellt, die der Einfachheit halber als $y_{a1}[1]$, $y_{a1}[2]$ und $y_{a1}[3]$ referenziert werden. Der Wert $y_{a1}[1]=9$ wird z.B. in $y_{a2}$ durch 9 binäre Einsen und 7(=16-9) binäre Nullen dargestellt. Zur besseren Lesbarkeit sind die Wortgrenzen hierbei durch ʼ|ʼ veranschaulicht sowie zur Verdeutlichung der Signalflanken die ʼ1ʼ jeweils überstrichen, die ʼ0ʼ unterstrichen dargestellt.

Die Bildung des Signals $y_{a3}$ erfolgt erfindungsgemäß folgendermaßen: da der erste Wert $y_{a1}[1]$ keinen vorangehenden Wert besitzt, wird die zugehörige Bitfolge unverändert von $y_{a2}$ nach $y_{a3}$ übernommen. Für den Wert $y_{a1}[1]$ endet die zugehörige Folge von $y_{a3}$ auf ʼ0ʼ. Da die zu $y_{a1}[2]$ zugehörige Folge in $y_{a2}$ mit ʼ1ʼ beginnt, wird diese Folge nun erfindungsgemäß umgedreht in $y_{a3}$ übernommen - also beginnend mit ihren binären Nullen. Für den Wert $y_{a1}[2]$ endet die zugehörige Folge von $y_{a3}$ somit auf ʼ1ʼ. Da die zu $y_{a1}[3]$ zugehörige Folge in $y_{a2}$ ebenfalls mit ʼ1ʼ beginnt, wird diese Folge nun unverändert nach $y_{a3}$ übernommen. Im Vergleich zum Signal $y_{a2}$ sind somit in $y_{a3}$ die Pulsflanken (1-0- bzw. 0-1-Übergänge) an den Wortgrenzen zwischen $y_{a1}[1]$ und $y_{a1}[2]$ sowie zwischen $y_{a1}[2]$ und $y_{a1}[3]$ entfallen.

```
                         Y_al[1]              Y_al[2]        Y_al[3]
    Y_al:        |<    9    >|<    4   >|<   10   >|

    Y_a2:        |1 1 1 1 1 1 1 1 1 0 0 0 0 0 0 0|1 1 1 0 0 0 0 0 0 0 0 0 0 0 0|1 1 1 1 1 1 1 1 1 1 0 0 0 0 0 0|  ...

    Y_a3:        |1 1 1 1 1 1 1 1 1 0 0 0 0 0 0 0|0 0 0 0 0 0 0 0 0 0 0 1 1 1 1|1 1 1 1 1 1 1 1 1 1 0 0 0 0 0 0|  ...
```

Durch die erfindungsgemäße Wort-Umdrehung werden folgende Vorteile erzielt:

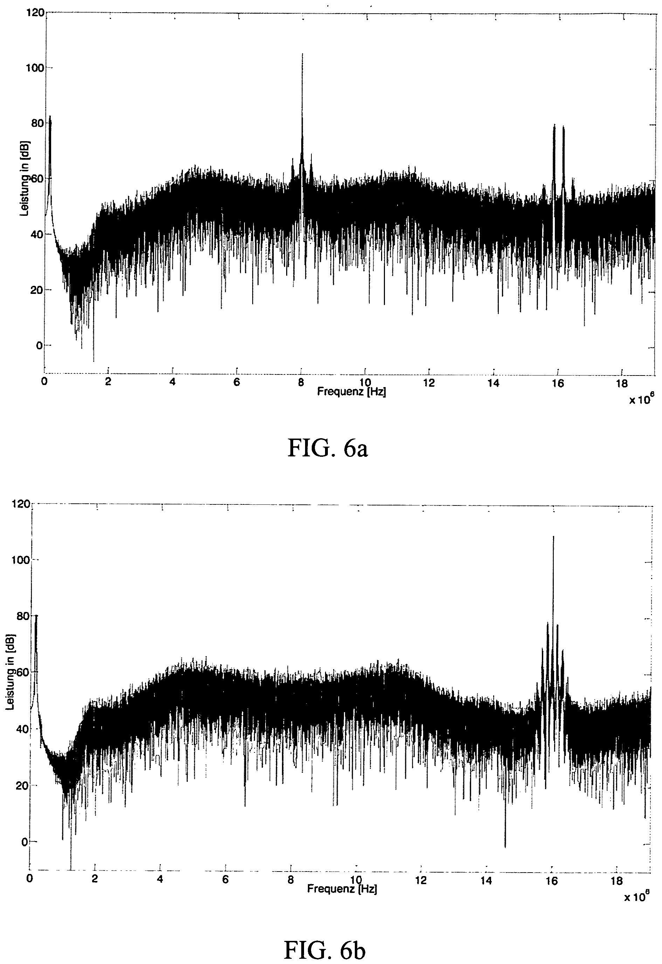

1- Die Trägerfrequenz, die durch die an festen Stellen anfangenden PDM-Pulse generiert wird, wird verschmiert (siehe das Leistungsspektrum des Ausgangssignals des Pulsdauermodulators PDM mit/ohne Wort-Umdrehung im Vergleich von **FIG. 6 a** und **6b**).

2- Schaltfrequenzen an Ausgangspulsen sind halbiert → verringerte Leistungsverluste.

3- Kurze Pulse (bzw. Kerben ("Notches") werden deutlich seltener.

Im Vergleich zu konventionellen NTF-Filtern, sind die Pole und Nullstellen in diesem Filter anders platziert, woraus eine bessere Stabilität resultiert. **FIG. 3** zeigt zwei optimale Stellen für die Pole und Nullstellen gemäß vorstehendem Aufsatz "A Reduced-Sample-Rate Sigma-Delta-Pipeline ADC Architecture for High-Speed High-Resolution Applications" von Vahid Majidzadeh und Omid Shoaei a.a.O. für die Architektur 4. Ordnung gemäß **FIG. 2**.

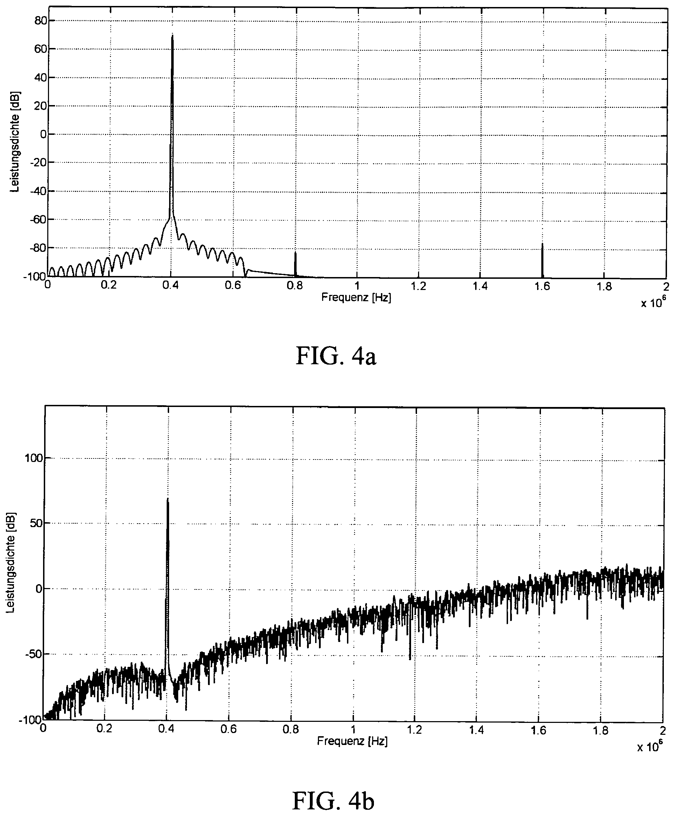

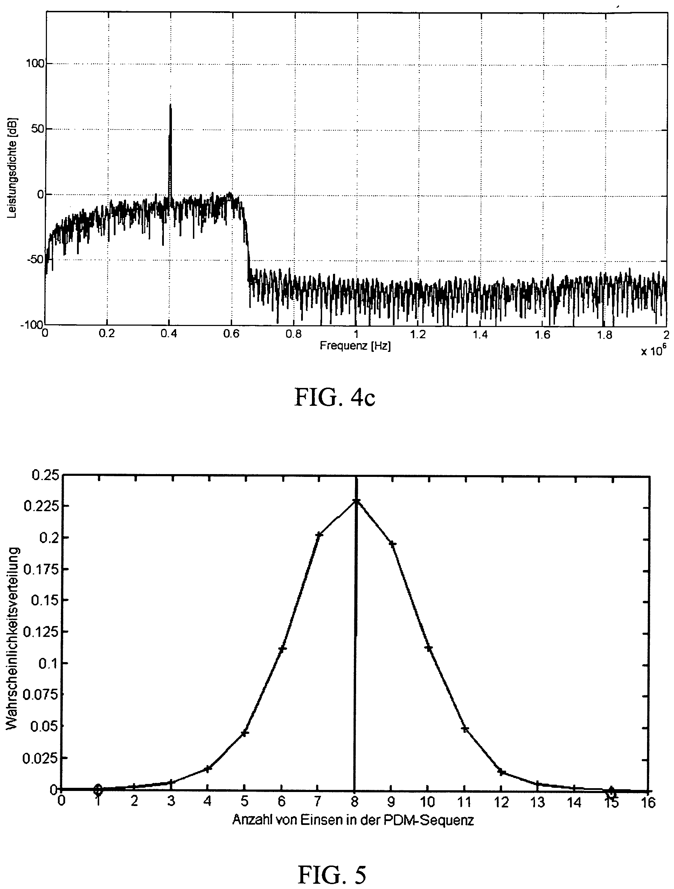

**FIG. 4** zeigt für ein Beispiel das Leistungsdichtespektrum für das Multibit-DSM-Signal an drei Stellen der erfindungsgemäßen Vorrichtung, nämlich am Systemeingang, am Quantisiererausgang und am Systemausgang. Der besseren Vergleichbarkeit wegen wurde hier ein Sinus verwendet.

Des Weiteren kam ein Reduced-Sampling-Rate-Filter 4. Ordnung zum Einsatz und der DSM verwendete ein Überabtastverhältnis von 8, so dass bei dem anliegenden Eingangssignal mit Abtastrate von 2 MSps am Ausgang des DSM ein Signal mit einer Taktrate von 16 MSps vorlag. Der Quantisierer am Ausgang des DSM erzeugte bei Unterscheidung von 17 Zuständen eine Folge von 5 Bit-Werten.

Aus diesem Beispiel wird deutlich, dass trotz des verwendeten niedrigen Überabtastfaktors (OSR) von 8 am Systemausgang das gewünschte SNR von mehr als 60 dB erreicht wird. Hieraus ist der deutliche Vorteil des erfindungsgemäßen Verfahrens/Vorrichtung gegenüber konventionellen Systemen zu erkennen, mit denen dies nicht zu erreichen wäre.

**FIG. 5** zeigt eine Wahrscheinlichkeitsverteilung der Anzahl Pulse innerhalb der PDM-Darstellung am Beispiel einer realen OFDM-Signalfolge (Trägerfrequenz fc=150 KHz, Bandbreite B=50 KHz) nach Verarbeitung durch den RSR-Delta-Sigma-Modulator und die anschließende erfindungsgemäße Parallel-Seriell-Umsetzung SPS. Hieraus ist zu erkennen, dass die kritischen Pulse (Pulse mit einer Eins aus insgesamt 16 Schlitzen oder 15 Einsen aus insgesamt 16 Schlitzen in der PDM-Sequenz entsprechend einem sehr kurzen (positiven) Puls oder einem sehr kurzen Einbruch) beim OFDM-Signal nur mit sehr geringer Wahrscheinlichkeit auftreten. Diese Wahrscheinlichkeit ist ohne das erfindungsgemäße Verfahren (nicht im **FIG. 5** dargestellt) deutlich höher und damit auch die Wahrscheinlichkeit einer Signalverschlechterung.

Gleichzeitig ergäbe sich im konventionellen Fall (d.h. ohne reduzierte Abtastrate) eine höhere Schaltfrequenz am Eingang des schaltenden Verstärkers CDA. Aufgrund der bereits erwähnten Tiefpasscharakteristik der Chip-Pads würde sich dadurch zusätzlich die Problematik mit der zuverlässigen Erkennung kurzer Schaltflanken verschärfen. Dies ist der Fall, da sich mit steigender Frequenz auch der Bereich - bezogen auf die Breite der Schaltflanken - im Abtasttakt erhöht, in dem Pulse nicht mehr zuverlässig erkannt werden können. Werden infolge der benutzten Chiptechnologie bei einer Taktfrequenz von 128 MHz am schaltenden Verstärker CDA nur Pulse einer Breite von 1 Abtasttakt nicht mehr zuverlässig erkannt, so gilt dies bei höherer Frequenz (ab ca. 256 MHz) auch für Pulse einer Breite von zwei Abtasttakten. Diese Verzerrung des Ausgangssignals ist auch vorstellbar, wenn man die Charakteristiken der Chip-Pads betrachtet. Für kurze Pulse (bzw. kurze Kerben) führen die typischen Verzögerungen bei steigenden Flanken (fallenden Flanken) zu Verzerrungen des Ausgangssignals.

Der Einsatz niedrigerer Taktfrequenzen, wie durch das erfindungsgemäße Verfahren möglich, wirkt sich durch die daraus resultierende Reduzierung von Signalverfälschungen zusätzlich positiv auf das SNR aus. Daraus wird deutlich, dass der Verwendung eines niedrigen OSR eine große Bedeutung zukommt.

**FIG. 6a** zeigt das Leistungsspektrum des Ausgangssignals eines PDM mit bzw. **FIG. 6b** ohne Wort-Umdrehung am Beispiel eines OFDM-Signals mit Trägerfrequenz (oder auch: Mittenfrequenz) 150 kHz und einer Nutzbandbreite von 50 kHz. Hierbei wurden ein Überabtastverhältnis (OSR) von 8 und eine Wortlänge von 16 am Ausgang des P/S-Umsetzers verwendet.

In **FIG. 6b** ist deutlich die PDM-Trägerfrequenz (16 MHz) als herausragende Spitze sowie weitere Anteile um diese Trägerfrequenz herum zu sehen. Die PDM-Trägerfrequenz überragt dabei die eigentlichen Signalfrequenzen um ca. 30 dB. Die Rauschanteile um das OFDM-Signal sind durch den DSM im Frequenzbereich nach oben verschoben, so dass im interessierenden Frequenzbereich ein SNR von knapp 50 dB vorliegt.

In **FIG. 6a** ist zu erkennen, dass -durch die spezielle P/S-Umsetzung und die damit erzielte Halbierung des Schalttakts - der Anteil bei der PDM-Trägerfrequenz größtenteils zur halben Trägerfrequenz (8 MHz) verschoben wurde. Gleiches gilt für einige deutlich niedrigere Anteile um die Trägerfrequenz herum. Durch einen nachfolgenden Rekonstruktionstiefpass (im vorliegenden Beispiel mit Grenzfrequenz 700 kHz) werden diese Signalanteile gefiltert. Zudem ergeben sich gegenüber dem in **FIG. 6b** dargestellten Fall die Vorteile, dass einerseits der von der Trägerfrequenz herrührende, markante Anteil (in **FIG. 6b** bei 16 MHz; in **FIG. 6a** nach 8 MHz verschoben) bereits um einige dB niedriger ist, und zum anderen auch die Anteile bei der niedrigeren Frequenz von 8 MHz günstiger bezüglich Abstrahlung sind.

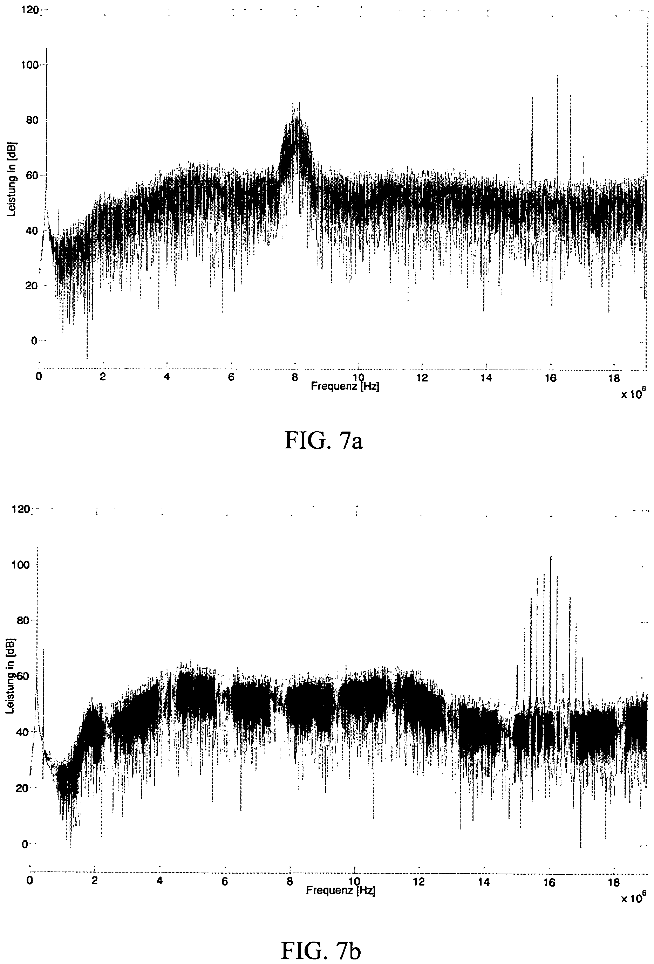

**FIG. 7a, 7b** zeigt im Wesentlichen das gleiche Ergebnis wie **FIG. 6a, 6b,** jedoch am Beispiel eines Sinussignals bei 200 kHz. Zu erkennen ist hier im Vergleich der beiden **FIG. 7a** und **FIG. 7b,** dass durch das erfindungsgemäße Verfahren die herausragende Spitze bei der Trägerfrequenz auf einen breiteren Bereich um die halbe Trägerfrequenz verschoben und "verschmiert" wurde. Zudem wurde der störende Anteil bei der doppelten Sinussignalfrequenz einerseits auf den umliegenden Frequenzbereich verschmiert, ein verbleibender markanter Anteil hat sich zudem in der Frequenz nach oben verschoben und wurde deutlich abgeschwächt (um mehr als 20 dB).

Aus den **FIG. 7a, 7b** und **FIG. 6a, 6b** werden damit folgende wesentliche Vorteile des erfindungsgemäßen Verfahrens deutlich:

- Die Anteile im hohen Frequenzbereich werden deutlich gesenkt, was sich deutlich positiv auf den Betrieb der Transistoren auswirkt.
- Störanteile in Umgebung der Signalfrequenzen werden deutlich gesenkt.

**FIG. 8** zeigt das Prinzip des erfindungsgemäßen, adaptiven, gedächtnisbehafteten Umdrehens der Pulse am Beispiel eines Signalausschnitts am Ausgang des speziellen P/S-Umsetzers. **FIG. 8a** zeigt die Sequenz der Pulse vor (bzw. ohne) Umdrehen und **FIG. 8b** nach dem Umdrehen. Hieraus ist die durch das Umdrehen bewirkte deutliche Reduktion der Anzahl der Signalflanken zu erkennen.

Die Funktionsweise der Ausgestaltung der Signalkonvertierung mittels Umdrehungsglied SHP und nachgeordnetem Parallel-Seriell-Umsetzer PSC zwischen Delta-Sigma-Modulator DSM und der mit diesem verbundenen schaltenden Verstärker CDA gemäß **FIG. 1b** ist analog, so dass daher auf eine nähere Erläuterung verzichtet wird. Dabei wird das parallele Ausgangssignal $y_{b1}$ des Quantisierers (Q) im Umdrehungsglied SHP durch ein adaptives, gedächtnisbehaftetes Umdrehen der Pulse derart verarbeitet, dass die Reihenfolge der binären Nullen und Einsen dieses Pulses (sofern vorhanden) vertauscht und dabei das Eingangssignal $y_{b1}$ wortweise in das Ausgangssignal $y_{b2}$ übergeführt wird. Nachfolgend wird im mit dem Umdrehungsglied SHP in Verbindung stehenden Parallel-Seriell-Umsetzer PSC das Multi-Bit-Ausgangssignal $y_{b2}$ des Umdrehungsglieds SHP mit der Tastfrequenz $f_{DSM}$ bei M Bits in ein PDM-ähnliches Ein-bit Signal $y_{b3}$ mit der Tastfrequenz $f_{PS,b}$, umwandelt, wobei abhängig vom jeweils anliegenden Multi-Bit-Wert des Eingangssignals $y_{b2}$ bei konstanter Frequenz der Tastgrad des Ausgangssignals $y_{b3}$ derart moduliert wird, dass pro Wort des Ausgangssignals $y_{b3}$ maximal ein Wechsel zwischen binären Einsen und Nullen bzw. Nullen und Einsen auftritt.

**FIG. 9** zeigt eine weitere Ausgestaltung der Architektur der erfindungsgemäßen Vorrichtung. Der Parallel-Seriell-Umsetzer SPS besteht dabei aus K parallel geschalteten Modulationstabellen MOT(k) mit einem nachgeschalteten Multiplexer MUX sowie einem diesem nachgeschaltetem Parallel-Seriell-Umsetzer PSC. In den Modulationstabellen MOT(k) wird jeder Multi-Bit-Eingangswert (vom DSM) auf eine (in der Regel) unterschiedliche Anordnung von binären Einsen und Nullen abgebildet, d.h. jeder M-Bit-Wert wird in ein Wort aus $N_{PS}$ aufeinanderfolgenden binären Werten umgesetzt. Der nachgeschaltete Multiplexer MUX stellt ein Mittel zur Selektion dar, der abhängig von einer Ansteuerung CTRL für jeden Takt eines Eingangswertes jeweils den Ausgang einer Modulationstabelle MOT(k), also das dort gebildete Wort, auf den Ausgang legt. Im nachgeordneten Parallel-Seriell-Umsetzer PSC erfolgt dann eine Umsetzung der binären Worte in serielle Binärwerte.

Im Beispiel der **FIG. 9** wird jeder 5-Bit-Wert am Ausgang des DSM in jeder der K nachgeschalteten Modulationstabellen MOT(k) in ein binäres Wort der Länge $N_{PS}= N_{DSM}-1=16$ konvertiert. Für die nachfolgende Darstellung kann wiederum vereinfachend angenommen werden, dass die 5-Bit-Werte des Signals $y_{a1}$ im Wertebereich [0; 16] vorliegen.

Die Konvertierung des Wertes $y_{a1}[n]$ in einer Modulationstabelle MOT(k) erfolgt vorzugsweise durch $y_{a1}[n]$ binäre Einsen und ($N_{PS}- y_{a1}[n]$) Nullen, wobei abhängig von der jeweiligen Modulationstabelle MOT(k) eine unterschiedliche Abbildung auf bzw. Anordnung von binären Einsen und Nullen resultiert. Im Gegensatz zum ebenfalls beschriebenen Spezialfall der Wortumdrehung ist die Anordnung dieser binären Einsen und Nullen prinzipiell beliebig, d.h. diese müssen nicht mehr zwangsläufig zusammenhängend sein. Dadurch wird zwar einerseits die Forderung zur Minimierung der Anzahl Schaltflanken aufgegeben, andererseits können durch geeignete Wahl der Modulationstabellen MOT(k) und deren Ansteuerung durch den Multiplexer MUX jedoch verbesserte spektrale Eigenschaften erzielt werden.

Die Steuerung/Steuerelement CTRL nimmt die Ansteuerung des Multiplexers MUX und damit die Selektion vor, welcher Ausgang welcher Modulationstabelle MOT(k) jeweils auf den Parallel-Seriell-Umsetzer PSC geschaltet wird und damit, welche Abbildung des M-Bit-Wertes am Ausgang des DSM auf ein binäres Wort jeweils auf den Eingang des PSC geschaltet werden soll. Diese Ansteuerung mittels Steuerung/ Steuerelement CTRL kann sowohl gedächtnisbehaftet; systematisch oder auch zufällig erfolgen. Bei der Implementierung einer zufälligen Ansteuerung wird für jedes Wort eine Zufallszahl erzeugt und damit erfolgt die Auswahl der für das jeweilige Wort anzuwendenden Modulationstabelle bzw. die Entscheidung, ob eine Umdrehung erfolgen soll. Der Nutzen liegt darin, dass durch die zufällige Auswahl der verwendeten Art der Umsetzung eines DSM-Ausgangswertes in eine konkrete Bitfolge, z.B. durch die für jedes Wort zufällige Auswahl einer der Modulationstabellen, eine spektrale Verteilung von Störanteilen aus dem Schalten des D-Verstärkers erreicht wird, wobei insbesondere diskrete Störlinien mit hoher Störamplitude in breitbandige Störanteile mit kleiner spektraler Leistungsdichte umgewandelt werden.

Die Anzahl K der zu verwendeten Modulationstabellen MOT(k), deren Inhalte (Abbildungsmuster) sowie die Art der Ansteuerung des Multiplexers durch die Steuerung/Steuerelement CTRL werden abhängig von den zu erzielenden Eigenschaften des Ausgangssignals und den Möglichkeiten in der Implementierung des schaltenden Verstärkers CDA gewählt. Somit kann beispielsweise bei der jeweiligen Ausgestaltung der Erfindung berücksichtigt werden, ob die Reduktion der Anzahl am Eingang des nachfolgenden CDA anliegender Schaltflanken oder die spektralen Eigenschaften des Ausgangssignals des CDA für die jeweilige Anwendung und Realisierung wichtiger sind.

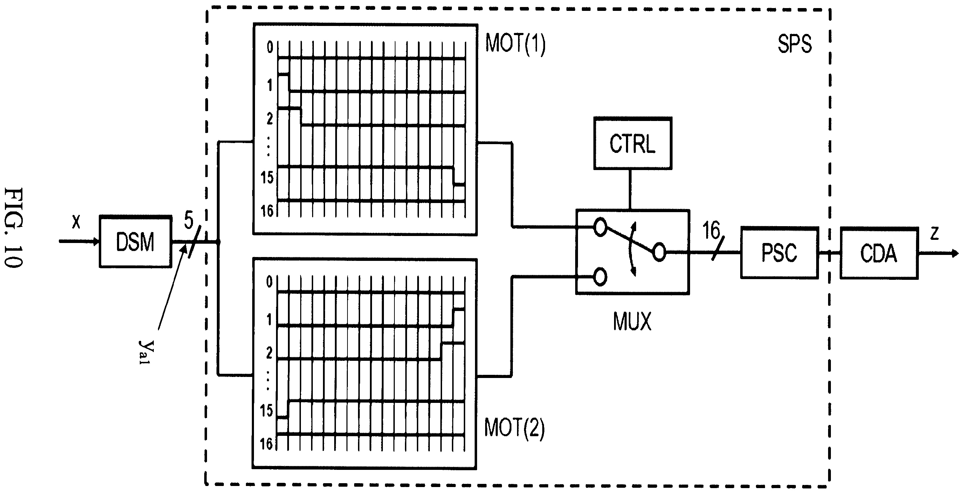

**FIG. 10** zeigt einen Spezialfall des in **FIG. 9** beschriebenen allgemeineren Falles. Die obere Modulationstabelle MOD(1) bildet den 5-Bit-Wert am Eingang jeweils auf ein Ein-Bit-PDM-Signal ab, die untere Modulationstabelle MOD(2) dagegen nimmt gegenüber MOD(1) eine umgedrehte Abbildung vor, d.h. hier sind die abgebildeten Worte gegenüber MOD(1) jeweils verdreht. Hieraus wird deutlich, dass dieser Spezialfall bei Verwendung einer gedächtnisbehafteten Ansteuerung des Multiplexers MUX dem bereits beschriebenen Vorgehen des adaptiven, gedächtnisbehafteten Umdrehens der Pulse entspricht. **FIG. 10** entspricht damit einer anderen Darstellung von **FIG. 1b.**

Die bisher beschriebenen Ausgestaltungen der Erfindung mit einer Reihenschaltung eines Parallel-Seriell-Umsetzers und eines Umdrehungsgliedes (SHS oder SHP) stellen somit Sonderfälle der erfindungsgemäßen Vorrichtung gemäß Anspruch 3 dar.

Die Erfindung ist nicht auf die beschriebenen Vorgehensweisen bzw. Funktionsblöcke beschränkt, sondern umfasst auch andere Vorgehensweisen, die den gleichen erfindungswesentlichen Effekt bewirken. So kann im Rahmen der Erfindung anstelle von P/S-Konvertierung und gedächtnisbehaftetem Umdrehen, wie in **FIG. 1a** und **FIG. 1b** dargestellt, auch eine P/S-Konvertierung mit direkter gedächtnisbehafteter Abbildung der Werte vorgenommen werden. Die Erzeugung des Ausgangspulses kann hierzu beispielsweise über einen Zähler (in der Zeichnung nicht dargestellt) erfolgen. Dieser wird am Beginn jedes Wortes zurückgesetzt. Bei Erreichung eines vorgegebenen Zählerstandes wird der Ausgang jeweils umgeschaltet.

In einem konkreten Ausführungsbeispiel ist dies folgendermaßen umgesetzt:

In der Normalreihenfolge (d.h. ohne Wortumdrehung) wird der Ausgang am Anfang jedes Wortes eingeschaltet und bei Erreichen des Zählerstandes gemäß dem Wert des DSM-Ausgangs (d.h. $y_{a1}$ bzw. $y_{a2}$ gemäß **FIG. 1a** bzw. **FIG. 1b**) wird der Ausgang ausgeschaltet.

In der invertierten Reihenfolge (d.h. mit Wortumdrehung) wird der Ausgang am Anfang jedes Wortes ausgeschaltet und bei Erreichen des Zählerstandes von [$N_{PS}$ - DSM-Ausgang] (d.h. [$NPS$ - $y_{a1}$] gemäß **FIG. 1a** bzw. [$NPS$ - $y_{a2}$] gemäß **FIG. 1b**) wird der Ausgang eingeschaltet ($N_{PS}$=Verhältnis Wort/Bitrate). Die Auswahl des jeweiligen Betriebsmodus (mit / ohne Wortumdrehung) erfolgt zu Beginn jedes Wortes auf Basis des letzten Bit des vorangegangenen Wortes.

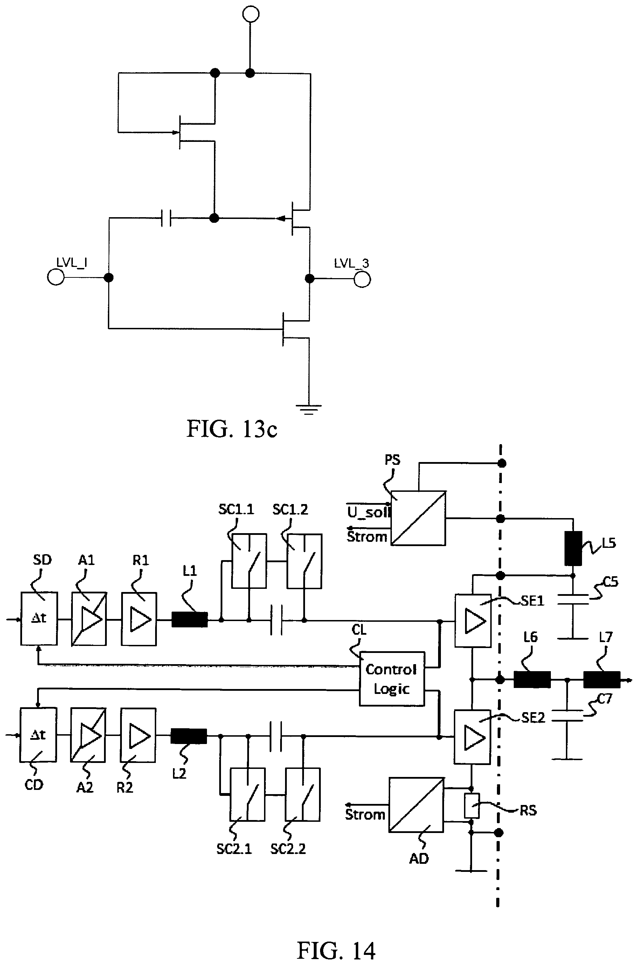

Die erfindungsgemäßen Vorrichtungen ermöglichen eine deutliche Erhöhung der Energieeffizienz, eine Reduktion der Verlustleistung und einen variablen Versorgungsspannungsbereich und damit eine Adaption der Dynamik mit optimalen SNR bei variabler Netzimpedanz und damit adaptierte variable Sendeleistung. Die Adaption der Versorgungspannung und die damit verbundene Sendeleistung, ermöglicht die Vermeidung der Überlast des Verstärkers CDA, sowie das Clipping des Nutzsignals und deren Verzerrung durch Sättigungseffekte (Induktivitäten, Restdifferenz zur Versorgungspannung, Übersteuerung, entspricht Nichtlinearitäten bzw. mangelnde Aussteuerung Reduktion der Reichweite). Die Bestimmung der Sendeleistung, Ausgangsleistung des schaltenden Verstärkers CDA kann, wie **FIG. 14** aufzeigt, durch Strommessung mittels Shunt RS am Schaltelement SE1, SE2 bei bekannten Ri bestimmt werden, oder in der Powersupply für den CDA, oder über den Empfängerkanal RXD des nachrichtentechnischen Systems beim aktiven Senden. Dabei entsprechen Verzögerungsschaltung SD, CD und Anpassglied A1, A2 den nach **FIG. 12** und in **FIG. 14** sind R1 und R2 Treiber mit Spule im Ausgang der letzten Boost-Capacitor (SC1.1, SC1.2, SC2.1, SC2.2) Endstufe, welche gleichzeitig als Resonanzvortreiber zur Flankengenerierung arbeitet.

## Patentansprüche

1. Vorrichtung mit einem Delta-Sigma-Modulator (DSM) und einem mit diesem verbundenen schaltenden Verstärker (CDA), bei der ein Audiosignal dem Eingang des Delta-Sigma-Modulators (DSM) zugeführt werden kann, wobei ein dem Delta-Sigma-Modulator (DSM) zugeführtes Eingangssignal in ein Ein-bit PDM-ähnliches Ausgangssignals ya2 mit maximal einem Wechsel zwischen binären Einsen und Nullen oder Nullen und Einsen umgesetzt wird, **dadurch gekennzeichnet, dass** am Multi-Bit-Ausgang des Delta-Sigma-Modulators (DSM) ein Parallel-Seriell Umsetzer SPS mit einer Reihenschaltung eines Parallel-Seriell-Umsetzers PSC und eines nachgeordneten Umdrehungsgliedes (SHS) für das serielle Ausgangssignal ya2 des Parallel-Seriell-Umsetzers PSC angeschlossen ist und der Parallel-Seriell Umsetzer SPS als Pulsdauermodulator jeden M-Bit-Wert in ein Wort aus $N_{ps}$ binären Werten umsetzt, und dass das Umdrehungsglied (SHS) abhängig vom letzten Bitwert 0 oder 1 eines jeweils vorhergehenden Wortes im resultierenden Ausgangssignal ya3 die Reihenfolge der binären Nullen und Einsen des aktuellen Wortes, sofern vorhanden, vertauscht, derart dass zur weiteren Reduzierung der Pulsflanken in dem Ausgangsignal ya2[i] des Parallel-Seriell Umsetzers PSC des Parallel-Seriell Umsetzers SPS dieses unverändert im resultierenden Ausgangssignal ya3[i] des Umdrehungsglieds (SHS) des Parallel-Seriell Umsetzers SPS übernommen wird, wenn ya3[i-l] mit demselben binären Wert endet wie ya2[i] beginnt, und ya2[i] umgedreht in ya3[i] übernommen wird, wenn ya3[i-1] mit dem entgegengesetzten binären Wert endet wie ya2[i] beginnt.

2. Vorrichtung mit einem Delta-Sigma-Modulator (DSM) und einem mit diesem verbundenen schaltenden Verstärker (CDA), bei der ein Audiosignal dem Eingang des Delta-Sigma-Modulators (DSM) zugeführt werden kann, wobei ein dem Delta-Sigma-Modulator (DSM) zugeführtes Eingangssignal in ein Ein-bit PDM-ähnliches Ausgangssignals ya2 mit maximal einem Wechsel zwischen binären Einsen und Nullen oder Nullen und Einsen umgesetzt wird, **dadurch gekennzeichnet, dass** am Multi-Bit-Ausgang des Delta-Sigma-Modulators (DSM) ein Parallel-Seriell Umsetzer SPS* mit einer Reihenschaltung aus einem Umdrehungsglied (SHP) für das parallele Ausgangssignal yb1 des Delta-Sigma-Modulators (DSM) und nachgeordnetem Parallel-Seriell-Umsetzer PSC angeschlossen ist und der Parallel-Seriell Umsetzer SPS als Pulsdauermodulator jeden M-Bit-Wert in ein Wort aus $N_{ps}$ binären Werten

umsetzt, und dass das Umdrehungsglied (SHP) abhängig vom letzten Bitwert 0 oder 1 eines jeweils vorhergehenden Wortes im resultierenden Ausgangsignal yb3 die Reihenfolge der binären Nullen und Einsen des aktuellen Wortes, sofern vorhanden, vertauscht, derart dass zur weiteren Reduzierung der Pulsflanken in dem Ausgangsignal des Parallel-Seriell Umsetzers SPS* in dem Ausgangsignal yb2[i] des Umdrehungsglied (SHP) dieses unverändert in yb3[i] übernommen wird, wenn yb3[i-1] mit demselben binären Wert endet wie yb2 [i] beginnt, und yb2[i] umgedreht in yb3[i] übernommen wird, wenn yb3[i-1] mit dem entgegengesetzten binären Wert endet wie yb2[i] beginnt.

3. Vorrichtung nach Anspruch 1, **dadurch gekennzeichnet, dass** am Ausgang des Delta-Sigma-Modulators (DSM) ein Quantisierer (Q) angeordnet ist, dass der mit dem Delta-Sigma-Modulator (DSM) in Verbindung stehende Parallel-Seriell-Umsetzers (PSC) das Multi-Bit-Ausgangssignal $y_{a1}$ des Quantisierers (Q) mit der Tastfrequenz $f_{DSM}$ bei M Bits in ein PDM-ähnliches Ein-bit Signal $y_{a2}$ mit der Tastfrequenz $f_{PS,a}$, umwandelt, wobei abhängig vom jeweils anliegenden Multi-Bit-Wert des Eingangssignals $y_{a1}$ bei konstanter Frequenz der Tastgrad des Ausgangssignals $y_{a2}$ derart moduliert wird, dass pro Wort des Ausgangssignals $y_{a2}$ maximal ein Wechsel zwischen binären Einsen und Nullen bzw. Nullen und Einsen auftritt.

4. Vorrichtung nach Anspruch 3, **dadurch gekennzeichnet, dass** zur Reduktion der Schaltfrequenz im mit dem Parallel-Seriell-Umsetzers (PSC) in Verbindung stehenden Umdrehungsglied (SHS) ein adaptives, gedächtnisbehaftetes Umdrehen von Pulsen (Worten) derart vorgenommen wird, dass die Reihenfolge der binären Nullen und Einsen des Pulses (sofern vorhanden) vertauscht und dabei das Eingangssignal $y_{a2}$ wortweise in das Ausgangssignal $y_{a3}$ übergeführt wird.

5. Vorrichtung nach Anspruch 2, **dadurch gekennzeichnet, dass** am Ausgang des Delta-Sigma-Modulators (DSM) ein Quantisierer (Q) angeordnet ist, dass das parallele Ausgangssignal $y_{b1}$ des Quantisierers (Q) im Umdrehungsglied (SHP) durch ein adaptives, gedächtnisbehaftetes Umdrehen von Pulsen (Worten) derart verarbeitet wird, dass die Reihenfolge der binären Nullen und Einsen des Pulses (sofern vorhanden) vertauscht und dabei das Eingangssignal $y_{b1}$ wortweise in das Ausgangssignal $y_{b2}$ übergeführt wird.

6. Vorrichtung nach Anspruch-5, **dadurch gekennzeichnet, dass** der mit dem Umdrehungsglied (SHP) in Verbindung stehende Parallel-Seriell-Umsetzer (PSC) das Multi-Bit-Ausgangssignal $y_{b2}$ des Umdrehungsglieds (SHP) mit der Tastfrequenz $f_{DSM}$ bei M Bits in ein PDM-ähnliches Ein-bit Signal $y_{b3}$ mit der Tastfrequenz $f_{PS,b}$, umwandelt, wobei abhängig vom jeweils anliegenden Multi-Bit-Wert des Eingangssignals $y_{b2}$ bei konstanter Frequenz der Tastgrad des Ausgangssignals $y_{b3}$ derart moduliert wird, dass pro Wort des Ausgangssignals $y_{b3}$ maximal ein Wechsel zwischen binären Einsen und Nullen bzw. Nullen und Einsen auftritt.

7. Vorrichtung nach Anspruch 1, **dadurch gekennzeichnet, dass** am Eingang des Delta-Sigma-Modulators (DSM) eine Überabtastung mit einem festlegbaren Überabtastfaktor stattfindet und dass nach der Überabtastung die Filterung des Signals in einem Schleifenfilter, welches ein Signalübertragungsfilter (Signal-Transfer-Filter) für das Eingangssignal des Delta-Sigma-Modulators (DSM) und ein Rauschübertragungsfilter (Noise-Transfer-Filter) für das rückgekoppelte Signal vom Ausgang eines Quantisierers Q des Delta-Sigma-Modulators DSM aufweist, stattfindet.

8. Vorrichtung nach Anspruch 7, **dadurch gekennzeichnet, dass** das Schleifenfilter aus der Klasse der RSR-Filter mit einem NTF-Filter höherer Ordnung die Übertragungsfunktion

$$H(z) = \frac{b_1 z^{-1} + b_2 z^{-2}}{1 - a_1 z^{-1} - a_2 z^{-2}}$$

aufweist.

9. Vorrichtung nach Anspruch 1, **dadurch gekennzeichnet, dass** der Delta-Sigma-Modulator (DSM) ein Register aufweist, in welches zur Rekonfiguration verschiedene Systemparameter geschrieben werden, um eine flexible Anpassung zu ermöglichen.

10. Vorrichtung nach einem der Ansprüche 1 bis 2, **dadurch gekennzeichnet, dass** der schaltende Verstärker (CDA) aus zwei parallelen Zweigen mit jeweils einer in Serie liegenden Verzögerungsschaltung (SD, CD), einem Anpassglied (A1, A2) zur Anpassung der Versorgungsspannung eines Schaltelements (S1, S2) und einem Resonanztreiber

(R1, R2) zur Schaltung des Schaltelements (S1, S2) besteht, dass in einer DLL-artigen Regelschleife die Schaltflanken am Ausgang des Resonanztreibers (R1, R2) abgegriffen und einem Phasenvergleicher zugeführt werden und dass aus der Differenz mittels einer Regelschaltung (RS) die Verzögerungszeit bestimmt und die Verzögerungsschaltung (CD) entsprechend eingestellt wird.

11. Vorrichtung nach Anspruch 10, **dadurch gekennzeichnet, dass** zur Bestimmung der Sendeleistung und Ausgangsleistung des schaltenden Verstärkers (CDA) eine Strommessung mittels Shunt (RS) am Schaltelement (SE1, SE2) bei bekannten Ri oder in einer Powersupply für den schaltenden Verstärker (CDA) oder über einen Empfängerkanal RXD eines nachrichtentechnischen Systems beim aktiven Senden erfolgt, so dass ein variabler Versorgungsspannungsbereich für den schaltenden Verstärkers (CDA) erzeugt wird.

**Claims**

1. An apparatus comprising a delta-sigma modulator (DSM) and a switching amplifier (CDA) connected thereto, wherein an audio signal can be supplied to the input of the delta-sigma modulator (DSM), wherein an input signal supplied to the delta-sigma modulator (DSM) is converted in a PDM-like one-bit signal ya2 with a maximum of one alternation between binary ones and zeroes or zeroes and ones, **characterized in that** a parallel-serial converter SPS that comprises, in series, a parallel-to-serial converter PSC and a subsequent swap element (SHS) for the serial output signal ya2 is connected to the multi-bit output of the delta-sigma modulator (DSM) and said parallel-serial converter SPS as PDM-modulator each M-bit word converts in a word of $N_{ps}$ binary words and wherein the swap element (SHS), based on a last bit value 0 or 1 of a preceding word in the output signal $y_{a3}$ reverses a sequence of binary zeroes and ones of a current word, where present, such as, for a further reducing the pulse edges of the output signal ya2[i] of said parallel-to-serial converter PSC belonging to said parallel-serial converter SPS, the resulting output signal ya3[i-1] of said swap element (SHS) belonging to said parallel-serial converter SPS is unchanged from said output signal ya2[i] if ya3[i-1] ends with the same binary word as ya2[i] begins and said output signal ya2[i] has been taken reverse in output signal ya3[i] if ya3[i-1] ends with the inverse binary word as ya2[i] begins.

2. An apparatus comprising a delta-sigma modulator (DSM) and a switching amplifier (CDA) connected thereto, wherein an audio signal can be supplied to the input of the delta-sigma modulator (DSM), ), wherein an input signal supplied to the delta-sigma modulator (DSM) is converted in a PDM-like one-bit signal ya2 with a maximum of one alternation between binary ones and zeroes or zeroes and ones, **characterized in that** a parallel-serial converter SPS* that comprises, in series, a subsequent swap element (SHS) for the parallel output signal yb1 of the delta-sigma modulator (DSM) and a parallel-to-serial converter PSC is connected to the multi-bit output of the delta-sigma modulator (DSM) and said parallel-serial converter SPS* as PDM-modulator each M-bit word converts in a word of $N_{ps}$ binary words and wherein the swap element (SHS), based on a last bit value 0 or 1 of a preceding word in the resulting output signal yb3 reverses a sequence of binary zeroes and ones of a current word, where present, such as, for a further reducing the pulse edges of the output signal of said parallel-to-serial converter SPS*, the signal yb3[i-1] is unchanged from said output signal yb2[i] of said swap element (SHP) if yb3[i-1] ends with the same binary word as yb2[i] begins and said output signal yb2[i] has been taken reverse in output signal yb3[i] if yb3[i-1] ends with the inverse binary word as yb2[i] begins.

3. The apparatus according to claim 1, wherein a quantizer (Q) is arranged at the output of the delta-sigma modulator (DSM), wherein said parallel-to-serial converter PSC connected to the delta-sigma-modulator (DSM) converts a multi-bit output signal $y_{a1}$ of the quantizer (Q) with a sampling frequency $f_{DSM}$ at M bits in a PDM-like one-bit signal $y_{a2}$ with a sampling frequency $f_{PS,a}$, wherein at a constant frequency and in dependence of a respective adjacent multi-bit value of the input signal $y_{a1}$, a duty cycle of the output signal $y_{a2}$ is modulated such that in each word of the output signal $y_{a2}$ a maximum of one alternation between binary ones and zeroes or zeroes and ones occurs.

4. The apparatus according to claim 3, wherein for reducing the switching frequency in the swap element (SHS) connected to the parallel-to-serial converter PSC an adaptive memory lossy swapping of pulses or words is performed such that the sequence of binary ones and zeroes of the pulse, where present, is reversed while the input signal $y_{a2}$ is word serially transferred to the output signal $y_{a3}$.

5. The apparatus according to claim 2, wherein a quantizer (Q) is arranged at the output of the delta sigma modulator (DSM), wherein a parallel output signal $y_{b1}$ of the quantizer (Q) is processed in the swap element (SHP) by an adaptive memory lossy flipping of pulses or words in such a way that a sequence of binary ones and zeroes of the pulse, where present, is reversed while the input signal $y_{b1}$ is word serially transferred to the output signal $y_{b2}$.

6. The apparatus according to claim 5, wherein the parallel-to-serial converter PSC connected to the swap element(SHP) converts the multi-bit output signal $y_{b2}$ of the swap element (SHP) with a sampling frequency $f_{DSM}$ at M bits in a PDM-like one-bit signal $y_{b3}$ with a sampling frequency $f_{PS,b}$ wherein at a constant frequency and in dependence of a respective adjacent multi-bit value of the input signal $y_{b2}$, a duty cycle of an output signal $y_{b3}$ is modulated such that in each word of the output signal $y_{b3}$ a maximum of one alternation between binary ones and zeroes or zeroes and ones occurs.

7. The apparatus according to claim 1, wherein at the input of the delta-sigma-modulator (DSM) an oversampling with a specifiable oversampling factor takes place and wherein after the oversampling a filtering of the signal takes place in a loop filter, comprising a signal-transfer-filter for the input signal of the delta-sigma-modulator (DSM) and a noise transfer filter for the feedback signal from the output of a quantizer (Q) of the delta-sigma modulator (DSM).

8. The apparatus according to claim 7, wherein the loop filter is of a class of RSR-filter with a NTF-filter of a higher order, having a transfer function

$$H(z) = \frac{b_1 z^{-1} + b_2 z^{-2}}{1 - a_1 z^{-1} - a_2 z^{-2}}.$$

.

9. The apparatus according to claim 1, wherein the delta-sigma modulator (DSM) has a register into which various system parameters are written that allows a flexible adaptation for reconfiguration of system parameters.

10. The apparatus according to one of claims 1 to 2, wherein the switching-type amplifier (CDA) comprises two parallel branches, each with a series connection of a delay circuit (SD, CD), a matching pad (A1, A2) for adjusting a supply voltage of a switching element (S1, S2), and a resonance driver (R1, R2) for switching of the switching element (S1, S2), wherein in a DLL-like control loop, switching edges at an output of the resonance driver (R1, R2) are tapped and fed to a phase comparator and wherein by means of a difference a regulating circuit (RS) determines a delay time and a delay circuit (CD) is adjusted accordingly.

11. The apparatus according to claim 10, wherein for determining a transmission power and an output power of the switching amplifier(CDA) a current measurement takes place in known Ri at a switching element (SE1, SE2) by means of a shunt (RS), or takes place at a power supply for the switching amplifier (CDA), or takes place during active transmission at a carrier receiver channel RXD of a communication system such that a variable power supply voltage range for a switching-type amplifier (CDA) is generated.

**Revendications**

1. Un appareil comprenant un modulateur delta-sigma (DSM) et un amplificateur de commutation (CDA) connecté à ce dernier, dans lequel un signal audio est envoyé a une entrée du modulateur delta-sigma (DSM), en ce que un signal entrant connecté à ce modulateur delta-sigma (DSM) est convertie dans un signal à un bit de type PDM avec un maximum d'un changement entre les binaires des uns et les zéros ou des zéros et des uns, **caractérisé en ce qu'**un convertisseur parallèle-série SPS avec un circuit série d'un convertisseur parallèle-série PSC et d'un élément de rotation (SHS) suivante pour le signal de sortie série ya2 d'un convertisseur parallèle-série PSC est connecté à la sortie multi-bits du modulateur delta-sigma (DSM) et le convertisseur parallèle-série SPS comme un modulateur de largeur d'impulsion convertie chaque valeur M bits d'un mot $N_{ps}$ de valeurs binaires et **en ce que** l'élément de rotation (SHS) dépend de la dernière valeur binaire 0 ou 1 d'un mot précédent respectif du signal de sortie résultant ya3 l'ordre de la séquence de zéros binaires et de un binaires du mot actuel, le cas échéant, est inversé, de sorte que pour la réduction poursuite des fronts d'impulsions du signal de sortie ya2[i] du convertisseur parallèle-série PSC partie du convertisseur parallèle-série SPS le signal de sortie ya2[i] est transférée inchangée de $y_{a2}$ à $y_{a3}$ résultant du convertisseur parallèle-série SPS si ya3[i-1] commencent avec le même valeur binaire comme ya2[i] est terminé et ya2[i] est maintenant adoptée inchangée si ya3[i-1] est terminé avec le valeur binaire inverse comme ya2[i] commence.

**2.** Un appareil comprenant un modulateur delta-sigma (DSM) et un amplificateur de commutation (CDA) connecté à ce dernier, dans lequel un signal audio est envoyé a une entrée du modulateur delta-sigma (DSM), en ce que un signal entrant connecté à ce modulateur delta-sigma (DSM) est convertie dans un signal à un bit de type PDM avec un maximum d'un changement entre les binaires des uns et les zéros ou des zéros et des uns, **caractérisé en ce qu'**un convertisseur parallèle-série SPS* avec un circuit série d'un élément de rotation (SHS) pour le signal de sortie parallèle yb1 du modulateur delta-sigma (DSM) et d'un convertisseur parallèle-série PSC suivante est connecté à la sortie multi-bits du modulateur delta-sigma (DSM) et le convertisseur parallèle-série SPS* comme un modulateur de largeur d'impulsion convertie chaque valeur M bits d'un mot $N_{ps}$ de valeurs binaires et **en ce que** l'élément de rotation (SHP) dépend de la dernière valeur binaire 0 ou 1 d'un mot précédent respectif du signal de sortie résultant yb3 l'ordre de la séquence de zéros binaires et de un binaires du mot actuel, le cas échéant, est inversé, de sorte que pour la réduction poursuite des fronts d'impulsions du signal de sortie yb2[i] du convertisseur parallèle-série SPS*, celui est transférée inchangée de yb2[i] à yb3[i] si yb3[i-1] est terminé avec le même valeur binaire comme yb2[i] commence et yb2[i] est maintenant adoptée inverse en yb3[i] si yb3[i-1] est terminé avec le valeur binaire inverse comme yb2[i] commence.

**3.** Appareil selon la revendication 1, **caractérisé en ce qu'**un quantificateur (Q) est disposé à la sortie du modulateur delta-sigma (DSM), que le convertisseur parallèle-série PSC en liaison avec le modulateur delta-sigma (DSM) convertit le multi-bit signal $y_{a1}$ du quantificateur (Q) avec la fréquence d'échantillonnage $f_{DSM}$ à M bits dans un signal à un bit de type PDM $y_{a2}$ avec la fréquence d'échantillonnage $f_{PS,a}$, en fonction de la valeur multi bits respectivement appliquée du signal d'entrée $y_{a1}$, à fréquence constante le rapport cyclique du signal de sortie $y_{a2}$ est modulé de sorte que par mot du signal de sortie $y_{a2}$ un maximum de un changement entre les binaires des uns et les zéros ou des zéros et des uns est générée.

**4.** Appareil selon la revendication 3, **caractérisé en ce que** pour réduire la fréquence de commutation dans l'élément de rotation (SHS) connecté avec le convertisseur parallèle-série PSC des impulsions ou mots sont faites inversées adaptatives et en mémoire de telle sorte que l'ordre les binaires des zéros et des uns du impulsion, si présent, et tandis que le signal d'entrée $y_{a2}$ est converti mot par mot en signal de sortie $y_{a3}$.

**5.** Appareil selon la revendication 2, **caractérisé en ce qu'**un quantificateur (Q) est disposé à la sortie du modulateur delta-sigma (DSM), que le signal de sortie parallèle $y_{b1}$ du quantificateur (Q) est traitées dans l'élément rotatif (SHP) par renversement adaptative et en mémoire d'impulsions ou du mots, de sorte que l'ordre les binaires des zéros et des uns du impulsion, si présent, est inversée et tandis que le signal d'entrée $y_{b1}$ est convertit mot par mot en signal de sortie $y_{b2}$.

**6.** Appareil selon la revendication 5, **caractérisé en ce que** le convertisseur parallèle-série PSC en liaison avec l'élément rotatif (SHP) transmet le signal de sortie multi-bits $y_{b2}$ de l'élément rotatif (SHP) à la fréquence d'échantillonnage $f_{DSM}$ à M bits dans un signal à un bit de type PDM $y_{b3}$ avec la fréquence d'échantillonnage $f_{PS,b}$, en fonction de la valeur multi bits respectivement appliquée du signal d'entrée $y_{b2}$, à fréquence constante de le rapport cyclique du signal de sortie $y_{b3}$ est modulé de sorte que par chaque mot du signal de sortie $y_{b3}$ un maximum de un changement entre les binaires des uns et les zéros ou des zéros et des uns est générée.

**7.** Appareil selon la revendication 1, **caractérisé en ce qu'**à l'entrée du modulateur delta-sigma (DSM) un sur échantillonnage est effectué avec un facteur de sur échantillonnage définissable et que après le sur échantillonnage le filtrage du signal ont lieu dans un filtre de boucle, qui comprend un filtre de transmission de signal pour le signal d'entrée du modulateur delta-sigma (DSM) et un filtre de transfert de bruit pour le signal de retour de la sortie d'un quantificateur (Q) du modulateur delta-sigma (DSM).

**8.** Appareil selon la revendication 7, **caractérisé en ce que** le filtre de boucle de la classe des filtres RSR avec un filtre NTF d'ordre supérieur, ayant la fonction de transfert

$$H(z) = \frac{b_1 z^{-1} + b_2 z^{-2}}{1 - a_1 z^{-1} - a_2 z^{-2}}.$$

**9.** Appareil selon la revendication 1, **caractérisé en ce que** le modulateur delta-sigma (DSM) comporte un registre dans lequel sont écrits différents paramètres de système à reconfigurer afin de permettre une adaptation flexible.

**10.** Appareil selon l'une des revendications 1 à 2, **caractérisé en ce que** l'amplificateur de commutation (CDA) comporte deux branches parallèles avec un circuit de retard (SD, CD) connecté en série, un élément d'adaptation (A1, A2) pour adapter la tension d'alimentation d'un élément de commutation (S1, S2) et un circuit de commande résonant (R1, R2) pour commuter l'élément de commutation (S1, S2) est que dans une boucle de commande de type DLL, les commutateurs en sortie du circuit de commande résonant (R1, R2) sont connectés à un comparateur de phase et à partir de la différence au moyen d'un circuit de commande (RS) détermine un temps de retard et un circuit de retard (CD) est réglé en conséquence.

**11.** Appareil selon la revendication 10, **caractérisé en ce que** pour déterminer la puissance d'émission et la puissance de sortie de l'amplificateur de commutation (CDA), une mesure de courant par shunt (RS) sur l'élément de commutation (S1, S2) si Ri est connue ou dans une alimentation de puissance pour l'amplificateur de commutation (CDA) ou via le canal récepteur RXD du système de télécommunication pendant la transmission active est fait, **en ce que** une plage de tension d'alimentation variable pour l'amplificateur de commutation(CDA) est généré.

FIG. 1a

FIG. 1b

NTF

$$X(z)$$

$$\frac{1}{z-1}$$

$$f$$

$$Q$$

$$\frac{\beta}{z-1}$$

b-Bit
ADC

$$Y(z)$$

$$g$$

$$-$$

$$H(z)$$

RSR

$$H(z) = \frac{b_1 z^{-1} + b_2 z^{-2}}{1 - a_1 z^{-1} - a_2 z^{-2}}$$

DSM

FIG. 2

Imaginärteil

Realteil (a)

Imaginärteil

Realteil (b)

FIG. 3

FIG. 4a

FIG. 4b

FIG. 4c

FIG. 5

FIG. 6a

FIG. 6b

FIG. 7a

FIG. 7b

23

a) ohne Wort-Drehung

b) mit Wort-Drehung

FIG. 8

2bit

1bit

$-U_B$  $+U_B$  $-3U_B$  $+3U_B$

...

z

y → Ansteuerung

FIG. 11

FIG. 9

FIG. 10

SD

A1

R1

PU

SE1

CD

A2

R2

B

PD

SE2

A

B

RS

| VHIGH2 | VHIGH2 | VHIGH2 |
| PU zu ¦ PU auf | PU zu ¦ PU auf | PU zu ¦ PU auf |

0V

0V

0V

PU und PD auf

PU und PD zu

12V

12V

12V

PD auf ¦ PD zu

PD auf ¦ PD zu

PD auf ¦ PD zu

0V

0V

0V

KURZSCHLUSS

THD

Optimaler Übergang

FIG. 12

VHIGH

VLVL_BP
ca. 1/3 Vhigh

VLVL_BN
ca 2/3 Vhigh

VDD

LVL_I

inp_int

inp_n

inp_int    inp_n

## FIG. 13a

VHIGH

LVL_02

VDD

LVL_I

inp_int

inp_n

## FIG. 13b

FIG. 13c

FIG. 14

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- GB 2438774 A
- GB 2435559 A
- GB 2406008 A
- US 5815102 A

- US 20100066580 A1
- WO 2010109453 A1
- DE 69919185 T2
- US 2010085118 A1


**In der Beschreibung aufgeführte Nicht-Patentliteratur**

- **RICHARD SCHREIER ; GABOR TEMES.** Understanding Delta-Sigma Data Converters. Wiley Interscience Publication, 2005
- **VAHID MAJIDZADEH.** A Reduced-Sample-Rate Sigma-Delta-Pipeline ADC Architecture for High-Speed High-Resolution Applications. *Omid Shoaei veröffentlicht in IEICE Transactions,* 2006, vol. 89-C (6), 692-701
- Delta-Sigma Modulators: modeling, design and application. **GEORGE BOUROPOULOS.** Imperial College Press. 2003
- **JURGEN VAN ENGELEN.** Stability Analysis and Design of Bandpass Sigma Delta Modulators. Technische Universität Eindhoven, 1999
- An Automatic Coefficient Design Methodology for High-Order Bandpass Sigma-Delta modulator with Single-Stage Structure. **HWI-MING WANG.** IEEE Transactions on Circuits and Systems II. Juli 2006, 580-584

- **WAN-RONE LIOU.** A Low-Power Multi-Bit Delta-sigma Modulator with Data Weighted Averaging Technique. *Workshop on Consumer Electronics and Signal Processing,* 2005
- **RICHARD SCHREIER ; GABOR TEMES.** Understanding Delta-Sigma Data Converters. Wiley Interscience Publication, 2005, 91ff
- Low-Voltage Sigma-Delta Modulator Topologies For Broadband Applications. **MOHAMMED YAVARI ; OMID SHOAEI.** IEEE International Symposium on Circuits and Systems. ISCAS, 2004, 465-468
- **VAHID MAJIDZADEH ; OMID SHOAEI.** A Reduced-Sample-Rate Sigma-Delta-Pipeline ADC Architecture for High-Speed High-Resolution Applications. *IEICE Transactions,* 2006, vol. 89-C (6), 692-701